# EUROPEAN PATENT APPLICATION

(11) **EP 4 191 524 A1**
(43) Date of publication of application: **07.06.2023**
(21) Application number: 21859485.1
(22) Date of filing: 11.01.2021
(51) Int. Cl.: G06T 7/13, H03K 3/64

(54) **DETECTION CIRCUIT, CHIP, AND ELECTRONIC DEVICE**

(30) Priority: 24.08.2020 CN 202010858330; 27.11.2020 CN 202011360776
(71) Applicant: Huawei Technologies Co., Ltd., Shenzhen, Guangdong 518129 (CN)
(72) Inventor: YAN, Peng, Shenzhen, Guangdong 518129 (CN)
(74) Representative: Körber, Martin Hans
(86) International application number: PCT/CN2021/071137
(87) International publication number: WO 2022/041632

(57) **Abstract**

This application relates to the field of signal processing technologies and discloses a detection circuit, a chip, and an electronic device, to help reduce calculation steps, improve calculation efficiency, and reduce power consumption of a device. The detection circuit includes: a first pulse sequence generator, configured to generate a first pulse sequence based on a first signal; a second pulse sequence generator, configured to generate a second pulse sequence based on a second signal, where amplitudes of the first signal and the second signal are different, and frequencies or amplitudes of the first pulse sequence and the second pulse sequence are different; a first conductance device, configured to receive the first pulse sequence to generate a first conductance; a second conductance device, configured to receive the second pulse sequence to generate a second conductance; and a difference detection circuit, configured to: when both the first conductance device and the second conductance device receive a third signal, output a voltage used to represent a difference between the first conductance and the second conductance. The detection circuit can be applied to an image edge detection scenario.

## Description

This application claims priority to Chinese Patent Application No. 202010858330.X, filed with the China National Intellectual Property Administration on August 24, 2020 and entitled "IMAGE PROCESSING METHOD AND CIRCUIT", and Chinese Patent Application No. 202011360776.6, filed with the China National Intellectual Property Administration on November 27, 2020 and entitled "DETECTION CIRCUIT, CHIP, AND ELECTRONIC DEVICE", which are incorporated herein by reference in their entireties.

### TECHNICAL FIELD

This application relates to the field of signal processing technologies, and in particular, to a detection circuit, a chip, and an electronic device.

### BACKGROUND

An image edge detection technology is widely applied to the fields such as image segmentation, motion detection, object tracking, and face recognition. Therefore, the image edge detection technology, as one of research hotspots of image processing technologies, mainly studies how to improve edge detection precision and apply the edge detection technology in actual engineering. The purpose of edge detection is to identify a point having an obvious brightness change in a digital image. A significant change in an image attribute usually reflects an important event and a change of the attribute, including discontinuity in depth, discontinuity in surface direction, a change in material attribute, a change in scene lighting, and the like.

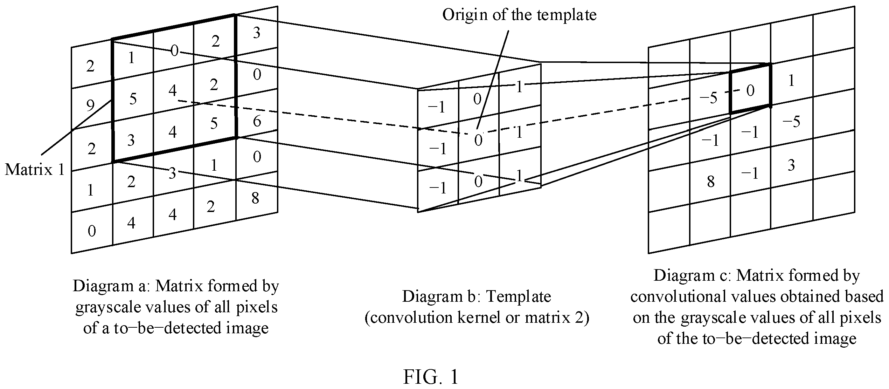

A principle of image edge detection may be classified into two types: searching for an extremum of a first derivative of an image and searching for a zero of a second derivative of an image. Because an image can be divided into a set of discrete pixels, calculation of a derivative of an image edge may be converted into a differential operation of grayscale values of pixels. In practice, template convolution is commonly used for approximate calculation. Specifically, an origin of a template (that is, a convolution kernel) is aligned with a pixel in a to-be-detected image, values of elements in the template are multiplied by a grayscale value of a corresponding pixel in the to-be-detected image, and products obtained are added to obtain a convolution value of the pixel. FIG. 1 is a schematic diagram of a convolution operation. In FIG. 1, after a matrix 1 formed by grayscale values of highlighted elements in a diagram a is multiplied by a matrix 2 shown in a diagram b, a value 0 of a highlighted element in a diagram c is obtained, and the value of the element is a convolution value of a central element "4" of the matrix 1 in the diagram a.

A convolution operation of the image requires the convolution kernel to move within an image range, to complete feature extraction for information of each pixel in the image and surrounding pixels. For example, with reference to FIG. 1, each element in the diagram a in FIG. 1 needs to be aligned with an origin of a template in the diagram b, and a matrix multiplication operation needs to be performed. For an image with a resolution of m×n, m×n convolution kernel movements, that is, m×n matrix multiplication operations, are required. This leads to a large calculation amount. Based on this, regardless of whether the convolution operation is implemented by using software or hardware, a problem of low calculation efficiency and high power consumption of a device used in a calculation process is caused because of the large calculation amount.

### SUMMARY

Embodiments of this application provide a detection circuit, a chip, and an electronic device, to help reduce calculation steps, improve calculation efficiency, and reduce power consumption of a device.

To achieve the foregoing objectives, the following technical solutions are used in embodiments of this application.

According to a first aspect, an embodiment of this application provides a detection circuit. The detection circuit includes: a first pulse sequence generator, configured to receive a first signal, and generate a first pulse sequence based on the first signal; a second pulse sequence generator, configured to receive a second signal, and generate a second pulse sequence based on the second signal, where amplitudes of the first signal and the second signal are different, and frequencies or amplitudes of the first pulse sequence and the second pulse sequence are different; a first conductance device, configured to receive the first pulse sequence to generate a first conductance; a second conductance device, configured to receive the second pulse sequence to generate a second conductance, where the first conductance device and the second conductance device are further configured to separately receive a third signal; and a difference detection circuit, configured to connect to the first conductance device and the second conductance device, where the difference detection circuit is further configured to output a difference voltage when both the first conductance device and the second conductance device receive the third signal, and the difference voltage is used to represent a difference between the first conductance and the second conductance.

In the detection circuit, a difference between the amplitudes of the first signal and the second signal is converted into a difference between the frequencies or the amplitudes of the pulse sequences, and then is converted into the difference between the first conductance and the second conductance. In this way, the difference between the first signal and the second signal can be indirectly detected by detecting the difference between the first conductance and the second conductance. The detection circuit may be applied to an image edge detection scenario, to reduce calculation steps, improve calculation efficiency, and reduce power consumption of a device. For a specific analysis process, refer to the description of embodiments below, and details are not described herein again.

In a possible design, a conductance of each of the first conductance device and the second conductance device changes with a frequency or an amplitude of a pulse sequence received by each of the first conductance device and the second conductance device.

In a possible design, the conductance of each of the first conductance device and the second conductance device increases, for example, increases linearly as the frequency of the pulse sequence received by each of the first conductance device and the second conductance device increases.

In a possible design, the conductance of each of the first conductance device and the second conductance device increases, for example, increases linearly as the amplitude of the pulse sequence received by each of the first conductance device and the second conductance device each increases.

In a possible design, the conductance of each of the first conductance device and the second conductance device increases, for example, increases linearly as a quantity of pulses in the pulse sequence received by each of the first conductance device and the second conductance device each increases.

In a possible design, the first conductance device and the second conductance device are volatile devices. At a first moment, the first conductance device receives the first pulse sequence, and the second conductance device receives the second pulse sequence. At a second moment, the first conductance device and the second conductance device separately receive the third signal. A time interval between the first moment and the second moment is less than or equal to an interval threshold. In this way, the first conductance device and the second conductance device generate the first conductance and the second conductance at the same time, and before the first conductance and the second conductance are initialized, the difference between the first conductance and the second conductance is detected.

In a possible design, the first conductance device and the second conductance device are non-volatile devices. The first conductance device is further configured to: after the difference detection circuit outputs the difference voltage, initialize the conductance of the first conductance device. The second conductance device is further configured to: after the difference detection circuit outputs the difference voltage, initialize the conductance of the second conductance device. In this way, subsequently, the detection circuit may be directly used to measure a difference between a new first signal and a new second signal.

In a possible design, both the first signal and the second signal are current signals or voltage signals.

In a possible design, the amplitudes of both the first pulse sequence and the second pulse sequence are greater than or equal to a first threshold. In other words, the first pulse sequence and the second pulse sequence can respectively change the conductances of the first conductance device and the second conductance device.

In a possible design, an amplitude of the third signal is less than the first threshold. In other words, the third signal cannot change the conductances of the first conductance device and the second conductance device, so that a difference between the first conductance and the second conductance is measured more accurately.

In a possible design, the first signal is an analog signal corresponding to a grayscale value of a first pixel in a to-be-detected image. The second signal is an analog signal corresponding to a grayscale value of a second pixel in the to-be-detected image. The first pixel is adjacent to the second pixel. In other words, the detection circuit may be configured to detect a difference between grayscale values of adjacent pixels, so that the detection circuit can be applied to an image edge detection scenario.

In a possible design, the detection circuit further includes a first differential amplifier. One input end of the first differential amplifier is configured to receive the difference voltage. The other input end of the first differential amplifier is configured to receive a reference voltage. A voltage output by the first differential amplifier is used to represent a gradient between the grayscale values of the first pixel and the second pixel. In other words, the detection circuit may be configured to detect a gradient between grayscale values of adjacent pixels, that is, the detection circuit can be applied to an image edge detection scenario.

In a possible design, one pixel pair in the to-be-detected image corresponds to one detection circuit. The pixel pair includes two adjacent pixels in a same row in the to-be-detected image, or two adjacent pixels in a same column in the to-be-detected image. In this way, an edge gradient image of the to-be-detected image can be obtained.

In a possible design, the first pixel pair in the to-be-detected image corresponds to a first detection circuit, and the second pixel pair in the to-be-detected image corresponds to a second detection circuit. Both the first pixel pair and the second pixel pair include a same pixel, and the first detection circuit and the second detection circuit share a same branch. The branch includes the first pulse sequence generator and the first conductance device, or the branch includes the second pulse sequence generator and the second conductance device. If this circuit structure is used for each row and each column of the to-be-detected image, a total of four parallel operations can be performed to complete calculation of gradients of all adjacent pixels in the to-be-detected image. If a manner of processing row by row and column by column is used, a detection circuit of a row-column scale may be reused, and a total of 2*(m+n) operations are required, to complete calculation of the gradients of all adjacent pixels in the to-be-detected image, so that a quantity of calculation times is reduced, calculation efficiency is improved, and power consumption of a device is reduced. A resolution of the to-be-detected image is m*n.

In a possible design, the first pixel pair in the to-be-detected image corresponds to a first detection circuit, and the second pixel pair in the to-be-detected image corresponds to a second detection circuit. Both the first pixel pair and the second pixel pair include a same pixel; and the first detection circuit and the second detection circuit share a pulse sequence generator corresponding to the same pixel. If this circuit structure is used for each row and each column of the to-be-detected image, a total of two parallel operations can be performed to complete calculation of the gradients of all adjacent pixels in the to-be-detected image. If a manner of processing row by row and column by column is used, a detection circuit of a row-column scale may be reused, and a total of (m+n) operations are required, to complete calculation of the gradients of all adjacent pixels in the to-be-detected image, so that a quantity of calculation times is reduced, calculation efficiency is improved, and power consumption of a device is reduced. A resolution of the to-be-detected image is m*n.

In a possible design, a third pixel pair in the to-be-detected image corresponds to a third detection circuit, and a fourth pixel pair in the to-be-detected image corresponds to a fourth detection circuit. Both the third pixel pair and the fourth pixel pair include the same pixel (that is the same pixel included in both the first pixel pair and the second pixel pair); and the third detection circuit and the fourth detection circuit share a pulse sequence generator corresponding to the same pixel. In this way, all rows and all columns of the to-be-detected image may be grouped in parallel, that is, edge detection operations of all elements are completed in one step, so that a quantity of calculation times is reduced, calculation efficiency is improved, and power consumption of a device is reduced.

In a possible design, the difference detection circuit includes a first resistor, a second resistor, and a second differential amplifier. The first pulse sequence generator, the first conductance device, and the first resistor are sequentially connected in series, and a connection point between the first resistor and the first conductance device is connected to one input end of the second differential amplifier. The second pulse sequence generator, the second conductance device, and the second resistor are sequentially connected in series, and a connection point between the second resistor and the second conductance device is connected to the other input end of the second differential amplifier. An output end of the second differential amplifier is used as an output end of the difference detection circuit. This possible design provides a circuit for detecting a difference between the first conductance and the second conductance. Certainly, specific implementation is not limited thereto.

According to a second aspect, an embodiment of this application provides a detection circuit. The detection circuit includes: a first pulse sequence generator, configured to receive a first signal, and generate a first pulse sequence based on the first signal; a second pulse sequence generator, configured to receive a second signal, and generate a second pulse sequence based on the second signal, where amplitudes of the first signal and the second signal are different, and frequencies of the first pulse sequence and the second pulse sequence are different; a first conductance device, configured to receive the first pulse sequence and the second pulse sequence to generate a first conductance; a second conductance device, configured to receive the first pulse sequence and the second pulse sequence to generate a second conductance; a first resistor and a second resistor, where the first conductance device and the first resistor are sequentially connected in series, and the second resistor and the second conductance device are sequentially connected in series, and a connection point between the first resistor and the second resistor is used as an output end of the detection circuit; and the output end of the detection circuit, configured to output a difference voltage, where the difference voltage is used to represent a difference between the first conductance and the second conductance.

In the detection circuit, a difference between the amplitudes of the first signal and the second signal is converted into a difference between the frequencies of the pulse sequences, and then is converted into the difference between the first conductance and the second conductance. In this way, the difference between the first signal and the second signal can be indirectly detected by detecting the difference between the first conductance and the second conductance. The detection circuit may be applied to an image edge detection scenario, to reduce calculation steps, improve calculation efficiency, and reduce power consumption of a device. For a specific analysis process, refer to the description of embodiments below, and details are not described herein again.

In a possible design, a conductance of each of the first conductance device and the second conductance device changes with a frequency of a pulse sequence received by each of the first conductance device and the second conductance device.

In a possible design, the conductance of each of the first conductance device and the second conductance device increases as a frequency of a positive pulse sequence received by each of the first conductance device and the second conductance device increases, and decrease as a frequency of a negative pulse sequence received by each of the first conductance device and the second conductance device increases.

In a possible design, the conductance of each of the first conductance device and the second conductance device increases as a quantity of pulses in a positive pulse sequence received by each of the first conductance device and the second conductance device increases, and decreases as a quantity of pulses in a negative pulse sequence received by each of the first conductance device and the second conductance device increases.

In a possible design, the first conductance device and the second conductance device are volatile devices. At a same moment, the first conductance device receives the first pulse sequence, and the second conductance device receives the second pulse sequence.

In a possible design, the first conductance device and the second conductance device are non-volatile devices. The first conductance device is further configured to: after the detection circuit outputs the difference voltage, initialize the conductance of the first conductance device. The second conductance device is further configured to: after the detection circuit outputs the difference voltage, initialize the conductance of the second conductance device. In this way, subsequently, the detection circuit may be directly used to measure a difference between a new first signal and a new second signal.

In a possible design, both the first signal and the second signal are current signals or voltage signals.

In a possible design, both the amplitudes of the first pulse sequence and the second pulse sequence are greater than or equal to a first threshold. In other words, the first pulse sequence and the second pulse sequence can respectively change the conductances of the first conductance device and the second conductance device.

In a possible design, the first signal is an analog signal corresponding to a grayscale value of a first pixel in a to-be-detected image. The second signal is an analog signal corresponding to a grayscale value of a second pixel in the to-be-detected image. The first pixel is adjacent to the second pixel. In other words, the detection circuit may be configured to detect a difference between grayscale values of adjacent pixels, so that the detection circuit can be applied to an image edge detection scenario.

In a possible design, the detection circuit further includes a first differential amplifier. One input end of the first differential amplifier is configured to receive the difference voltage. The other input end of the first differential amplifier is configured to receive a reference voltage. A voltage output by the first differential amplifier is used to represent a gradient between the grayscale values of the first pixel and the second pixel. In other words, the detection circuit may be configured to detect a gradient between grayscale values of adjacent pixels, that is, the detection circuit can be applied to an image edge detection scenario.

In a possible design, one pixel pair in the to-be-detected image corresponds to one detection circuit. The pixel pair includes two adjacent pixels in a same row in the to-be-detected image, or two adjacent pixels in a same column in the to-be-detected image. In this way, an edge gradient image of the to-be-detected image can be obtained.

In a possible design, the first pixel pair in the to-be-detected image corresponds to a first detection circuit, and the second pixel pair in the to-be-detected image corresponds to a second detection circuit. Both the first pixel pair and the second pixel pair include a same pixel, and the first detection circuit and the second detection circuit share a same branch. The branch includes the first pulse sequence generator and the first conductance device, or the branch includes the second pulse sequence generator and the second conductance device. If this circuit structure is used for each row and each column of the to-be-detected image, a total of four parallel operations can be performed to complete calculation of gradients of all adjacent pixels in the to-be-detected image. If a manner of processing row by row and column by column is used, a detection circuit of a row-column scale may be reused, and a total of 2*(m+n) operations are required, to complete calculation of the gradients of all adjacent pixels in the to-be-detected image, so that a quantity of calculation times is reduced, calculation efficiency is improved, and power consumption of a device is reduced. A resolution of the to-be-detected image is m*n.

In a possible design, the first pixel pair in the to-be-detected image corresponds to a first detection circuit, and the second pixel pair in the to-be-detected image corresponds to a second detection circuit. Both the first pixel pair and the second pixel pair include a same pixel; and the first detection circuit and the second detection circuit share a pulse sequence generator corresponding to the same pixel. If this circuit structure is used for each row and each column of the to-be-detected image, a total of two parallel operations can be performed to complete calculation of the gradients of all adjacent pixels in the to-be-detected image. If a manner of processing row by row and column by column is used, a detection circuit of a row-column scale may be reused, and a total of (m+n) operations are required, to complete calculation of the gradients of all adjacent pixels in the to-be-detected image, so that a quantity of calculation times is reduced, calculation efficiency is improved, and power consumption of a device is reduced. A resolution of the to-be-detected image is m*n.

In a possible design, a third pixel pair in the to-be-detected image corresponds to a third detection circuit, and a fourth pixel pair in the to-be-detected image corresponds to a fourth detection circuit. Both the third pixel pair and the fourth pixel pair include the same pixel (that is the same pixel included in both the first pixel pair and the second pixel pair); and the third detection circuit and the fourth detection circuit share a pulse sequence generator corresponding to the same pixel. In this way, all rows and all columns of the to-be-detected image may be grouped in parallel, that is, edge detection operations of all elements are completed in one step, so that a quantity of calculation times is reduced, calculation efficiency is improved, and power consumption of a device is reduced.

According to a third aspect, an embodiment of this application provides a chip. The chip includes any detection circuit provided in the first aspect and the possible designs of the first aspect.

According to a fourth aspect, an embodiment of this application provides a chip. The chip includes any detection circuit provided in the second aspect and the possible designs of the second aspect.

According to a fifth aspect, an embodiment of this application provides an electronic device, and the electronic device includes any chip provided in the third aspect.

According to a sixth aspect, an embodiment of this application provides an electronic device, and the electronic device includes any chip provided in the fourth aspect.

According to a seventh aspect, an embodiment of this application provides an electronic device, and the electronic device includes any detection circuit provided in the first aspect and the possible designs of the first aspect.

According to an eighth aspect, an embodiment of this application provides an electronic device, and the electronic device includes the detection circuit according to any one of the second aspect and the possible designs of the second aspect.

According to a ninth aspect, an embodiment of this application provides an image processing method. The method includes:
constructing a grayscale value difference detection circuit of adjacent pixels, and performing grayscale value difference detection of a complete image based on grouping in X and Y directions to obtain an X component and a Y component of an edge gradient of two adjacent pixels; and
combining an X component and a Y component of a same pixel to obtain an edge gradient output of the complete image for implementing an edge detection function.

In a possible design, there are two circuit implementations for detecting a grayscale value difference between adjacent pixels. A principle is that different input grayscale values are first converted into pulse sequences with different frequencies or amplitudes, and then output is completed by using a response difference of a resistor device to the different pulse sequences. If a final output is a zero level, it indicates that no edge exists. If a final output is a high level, it indicates that an edge exists and an amplitude of the high level is directly proportional to an edge gradient. A difference between the two circuits lies in operation steps. If the converted pulse sequences are input to separately function on the resistor devices, two operations are required to complete the final output. If the converted pulse sequences are input to simultaneously function on the resistor devices, only one operation is required to complete the final output.

In a possible design, there are three usages methods combined for the grayscale value difference detection circuit of adjacent pixels. For an image with a resolution of m×n, three structures may be used to concurrently output an edge detection result. If each pixel corresponds to one device, at least four parallel operations are performed. If each pixel corresponds to two devices, at least two parallel operations are performed. If each pixel corresponds to four devices, at least one parallel operation is performed. After a parallel operation output is complete, components of coordinates of a same pixel are combined to obtain edge gradient information of the entire image.

In a possible design, the method further includes:
A device in a basic edge detection unit may be a resistance-volatile device, or may be a resistance-non-volatile device. For the volatile device, two input signals need to be applied simultaneously and an output result needs to be read in time.

It should be understood that, for beneficial effects achieved by the technical solutions in the third aspect to the ninth aspect and the corresponding possible implementations of the third aspect to the ninth aspect of embodiments of this application, refer to the foregoing technical effects of the first aspect and the corresponding possible designs of the first aspect or the second aspect and the corresponding possible designs of the second aspect. Details are not described herein again.

### BRIEF DESCRIPTION OF DRAWINGS

FIG. 1 is a schematic diagram of a convolution operation according to a conventional technology;
FIG. 2 is a schematic diagram of a structure of a detection circuit according to an embodiment of this application;
FIG. 3 is a schematic diagram of an electrical characteristic of a conductance device applicable to the detection circuit shown in FIG. 2;
FIG. 4 is a schematic diagram of an electrical characteristic of another conductance device applicable to the detection circuit shown in FIG. 2;
FIG. 5 is a schematic diagram of a working principle of a circuit for converting a first signal and a second signal into a first conductance and a second conductance according to an embodiment of this application;
FIG. 6a is a schematic diagram of a working principle of a circuit for detecting a difference between a first conductance and a second conductance according to an embodiment of this application;
FIG. 6b is a schematic diagram of a working principle of another circuit for detecting a difference between a first conductance and a second conductance according to an embodiment of this application;
FIG. 7 is a schematic diagram of a structure of another detection circuit based on FIG. 2 according to an embodiment of this application;
FIG. 8 is a schematic diagram of a structure of another detection circuit based on FIG. 7 according to an embodiment of this application;
FIG. 9 is a schematic diagram of a grouping result of an image with a resolution of m×n according to an embodiment of this application;
FIG. 10 is a schematic diagram of a structure of a circuit for performing edge detection on elements in a first row of a to-be-detected image based on FIG. 8 according to an embodiment of this application;
FIG. 11 is a schematic diagram of a structure of another circuit for performing edge detection on elements in a first row of a to-be-detected image based on FIG. 8 according to an embodiment of this application;
FIG. 12 is a schematic diagram of a structure of a circuit for performing edge detection on some elements in a to-be-detected image based on FIG. 8 according to an embodiment of this application;
FIG. 13 is a schematic diagram of a structure of another detection circuit according to an embodiment of this application;
FIG. 14 is a schematic diagram of an electrical characteristic of a conductance device applicable to the detection circuit shown in FIG. 13;
FIG. 15 is a schematic diagram of a structure of a detection circuit based on FIG. 13 according to an embodiment of this application;
FIG. 16 is a schematic diagram of a structure of a circuit for performing edge detection on elements in a first row of a to-be-detected image based on FIG. 15 according to an embodiment of this application; and
FIG. 17 is a schematic diagram of a structure of another circuit for performing edge detection on elements in a first row of a to-be-detected image based on FIG. 15 according to an embodiment of this application.

### DESCRIPTION OF EMBODIMENTS

In embodiments of this application, the word "example", "for example", or the like is used to represent giving an example, an illustration, or a description. Any embodiment or design scheme described as "example" or "for example" in embodiments of this application should not be explained as being more preferred or having more advantages than another embodiment or design scheme. Exactly, use of the word "example", "for example", or the like is intended to present a related concept in a specific manner.

The terms "first" and "second" in embodiments of this application are merely intended for a purpose of description, and shall not be understood as an indication or implication of relative importance or implicit indication of a quantity of indicated technical features. Therefore, a feature limited by "first" or "second" may explicitly or implicitly include one or more features. In the descriptions of this application, unless otherwise stated, "a plurality of means two or more than two.

In this application, the term "at least one" means one or more, and the term "a plurality of means two or more. For example, a plurality of second packets mean two or more second packets.

It should be understood that the terms used in the descriptions of various examples in this specification are merely intended to describe specific examples, but are not intended to constitute a limitation. The terms "one" ("a" and "an") and "the" of singular forms used in the descriptions of various examples and the appended claims are also intended to include plural forms, unless otherwise specified in the context clearly.

It should be further understood that, the term "and/or" used in this specification indicates and includes any or all possible combinations of one or more items in associated listed items. The term "and/or" describes an association relationship between associated objects and represents that three relationships may exist. For example, A and/or B may represent the following three cases: Only A exists, both A and B exist, and only B exists. In addition, the character "/" in this application generally indicates an "or" relationship between associated objects.

It should be further understood that sequence numbers of processes do not mean execution sequences in embodiments of this application. The execution sequences of the processes should be determined based on functions and internal logic of the processes, and should not be construed as any limitation on the implementation processes of embodiments of this application.

It should be understood that determining B based on A does not mean that B is determined based on only A, but B may alternatively be determined based on A and/or other information.

It should be further understood that the term "include" (or referred to as "includes", "including", "comprises", and/or "comprising"), when being used in this specification, specifies the presence of stated features, integers, steps, operations, elements, and/or components, but do not preclude the presence or addition of one or more other features, integers, steps, operations, elements, components, and/or groups thereof.

It should be further understood that the term "if" may be interpreted as a meaning "when" ("when" or "upon"), "in response to determining", or "in response to detecting". Similarly, according to the context, the phrase "if it is determined that" or "if (a stated condition or event) is detected" may be interpreted as a meaning of "when it is determined that", "in response to determining", "when (a stated condition or event) is detected", or "in response to detecting (a stated condition or event)".

It should be understood that "one embodiment", "an embodiment", and "a possible implementation" mentioned in the entire specification mean that particular features, structures, or characteristics related to the embodiment or the implementation are included in at least one embodiment of this application. Therefore, "in one embodiment", "in an embodiment", or "in a possible implementation" appearing throughout this specification does not necessarily mean a same embodiment. In addition, these particular features, structures, or characteristics may be combined in one or more embodiments by using any appropriate manner.

With reference to the accompanying drawings, the following describes the technical solutions provided in embodiments of this application.

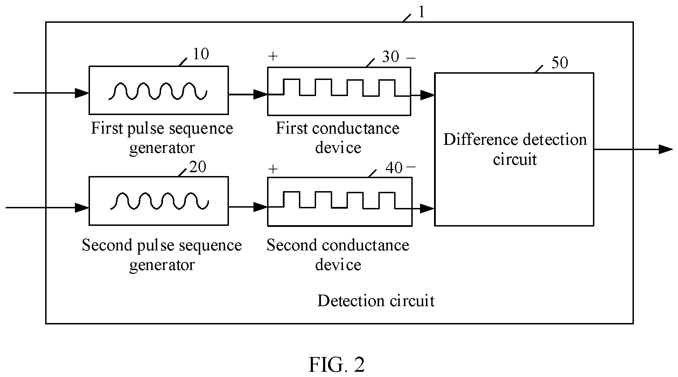

FIG. 2 is a schematic diagram of a structure of a detection circuit 1 according to an embodiment of this application.

The detection circuit 1 includes: a first pulse sequence generator 10, a second pulse sequence generator 20, a first conductance device 30, a second conductance device 40, and a difference detection circuit 50.

The first pulse sequence generator 10 is configured to receive a first signal, and generate a first pulse sequence based on the first signal.

The second pulse sequence generator 20 is configured to receive a second signal, and generate a second pulse sequence based on the second signal. Amplitudes of the first signal and the second signal are different, and frequencies or amplitudes of the first pulse sequence and the second pulse sequence are different.

The first conductance device 30 is configured to receive the first pulse sequence to generate a first conductance.

The second conductance device 40 is configured to receive the second pulse sequence to generate a second conductance.

The first conductance device 30 and the second conductance device 40 are further configured to separately receive a third signal.

The difference detection circuit 50 is configured to connect to the first conductance device 30 and the second conductance device 40.

The difference detection circuit 50 is further configured to output a difference voltage when both the first conductance device 30 and the second conductance device 40 receive the third signal. The difference voltage is used to represent a difference between the first conductance and the second conductance.

Optionally, both the first signal and the second signal are current signals or voltage signals.

The first signal and the second signal may be different based on different application scenarios of the detection circuit 1. For example, if the detection circuit 1 is configured to detect a difference between grayscale values of two pixels, the first signal and the second signal may be current signals (or voltage signals) obtained after the grayscale values of the two pixels are converted. For another example, if the detection circuit 1 is configured to detect a difference between two characters, the first signal and the second signal may be current signals (or voltage signals) obtained after the two characters are converted.

Optionally, the first pulse sequence generator 10 and the second pulse sequence generator 20 have a same hardware structure and a same hardware parameter.

For example, the first pulse sequence generator 10 and the second pulse sequence generator 20 are pulse sequence generators of a same model. In this way, a difference between the frequencies or the amplitudes of the first pulse sequence and the second pulse sequence caused by a hardware difference between the first pulse sequence generator 10 and the second pulse sequence generator 20 can be reduced, so that a difference between the first pulse sequence and the second pulse sequence can more accurately represent a difference between the first signal and the second signal, and a detection result of the detection circuit 1 is more accurate.

Optionally, the first conductance device 30 and the second conductance device 40 have a same hardware structure, and have a same initial hardware parameter.

That the first conductance device 30 and the second conductance device 40 have a same initial hardware parameter means that an initial conductance of the first conductance device 30 is the same as an initial conductance of the second conductance device 40, or a difference between the initial conductances is within a preset range. For example, the first conductance device 30 and the second conductance device 40 are conductance devices of a same model. In this way, a difference between the first conductance and the second conductance caused by a hardware difference between the first conductance device 30 and the second conductance device 40 can be reduced, so that a difference between the first conductance and the second conductance can more accurately represent a difference between the first pulse sequence and the second pulse sequence, and can more accurately represent a difference between the first signal and the second signal, and a detection result of the detection circuit 1 is more accurate.

Optionally, directions of the first pulse sequence and the second pulse sequence are the same. For example, the first pulse sequence is a positive pulse sequence relative to the first conductance device 30, and the second pulse sequence is a positive pulse sequence relative to the second conductance device 40. For example, the first pulse sequence is a negative pulse sequence relative to the first conductance device 30, and the second pulse sequence is a negative pulse sequence relative to the second conductance device 40.

In this case, as shown in FIG. 2, positive electrodes of the first conductance device 30 and the second conductance device 40 are respectively connected to the first pulse sequence generator 10 and the second pulse sequence generator 20, and negative electrodes of the first conductance device 30 and the second conductance device 40 are both connected to the difference detection circuit 50. Alternatively, negative electrodes of the first conductance device 30 and the second conductance device 40 are respectively connected to the first pulse sequence generator 10 and the second pulse sequence generator 20, and positive electrodes of the first conductance device 30 and the second conductance device 40 are both connected to the difference detection circuit 50.

Optionally, both the first pulse sequence and the second pulse sequence may include one or more pulses. Correspondingly, other pulse sequences in the following, such as a third pulse sequence and a fourth pulse sequence, may also include one or more pulses. When the pulse sequence includes one pulse, the pulse sequence is specifically a single pulse.

Optionally, duration for receiving the first pulse sequence by the first conductance device 30 is the same as duration for receiving the second pulse sequence by the second conductance device 40. In other words, the first pulse sequence and the second pulse sequence respectively function on the first conductance device 30 and the second conductance device 40 for same duration.

In the detection circuit 1, the first conductance device 30 and the second conductance device 40 have electrical characteristics as follows.

Optionally, a conductance of each of the first conductance device 30 and the second conductance device 40 changes with a quantity of pulses in a pulse sequence received by each of the first conductance device 30 and the second conductance device 40.

For example, the conductance of each of the first conductance device 30 and the second conductance device 40 increases, for example, increases linearly as the quantity of pulses in the pulse sequence received by each of the first conductance device 30 and the second conductance device 40 increases.

For another example, the conductance of each of the first conductance device 30 and the second conductance device 40 separately decreases, for example, decreases linearly as the quantity of pulses in the pulse sequence received by each of the first conductance device 30 and the second conductance device 40 increases.

In some optional implementations, a conductance of each of the first conductance device 30 and the second conductance device 40 changes with a frequency of a pulse sequence received by each of the first conductance device 30 and the second conductance device 40. In this case, the detection circuit 1 may convert the difference between the first signal and the second signal into a difference between the frequencies of the first pulse sequence and the second pulse sequence.

For example, the conductance of each of the first conductance device 30 and the second conductance device 40 increases, for example, increases linearly as the frequency of the pulse sequence received by each of the first conductance device 30 and the second conductance device 40 increases.

For another example, the conductance of each of the first conductance device 30 and the second conductance device 40 separately decreases, for example, decreases linearly as the frequency of the pulse sequence received by each of the first conductance device 30 and the second conductance device 40 increases.

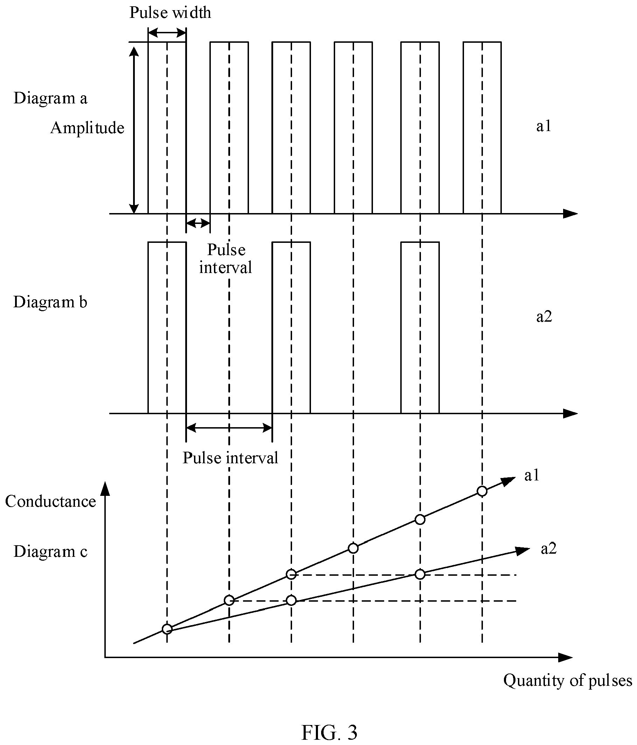

FIG. 3 is a schematic diagram of an electrical characteristic of a conductance device. A diagram a and a diagram b in FIG. 3 respectively show a pulse sequence a1 and a pulse sequence a2. Pulse widths and amplitudes of the two pulse sequences are the same, but pulse intervals of the two pulse sequences are different. Therefore, frequencies of the two pulse sequences are different. A diagram c in FIG. 3 shows a conductance change that is of the conductance device and that is obtained when the conductance device receives the pulse sequence a1 and the pulse sequence a2 separately.

It can be learned from FIG. 3 that, for a specific pulse sequence, a conductance of the conductance device linearly increases as a quantity of pulses received by the conductance device increases. For a plurality of pulse sequences, a conductance of the conductance device increases as a frequency of a pulse sequence received by the conductance device increases.

In some other optional implementations, a conductance of each of the first conductance device 30 and the second conductance device 40 changes with an amplitude of a pulse sequence received by each of the first conductance device 30 and the second conductance device 40. In this case, the detection circuit 1 may convert a difference between a first signal and a second signal into a difference between amplitudes of a first pulse sequence and a second pulse sequence.

For example, the conductance of each of the first conductance device 30 and the second conductance device 40 increases, for example, increases linearly as the amplitude of the pulse sequence received by each of the first conductance device 30 and the second conductance device 40 increases.

For another example, the conductance of each of the first conductance device 30 and the second conductance device 40 separately decreases, for example, decreases linearly as the amplitude of the pulse sequence received by each of the first conductance device 30 and the second conductance device 40 increases.

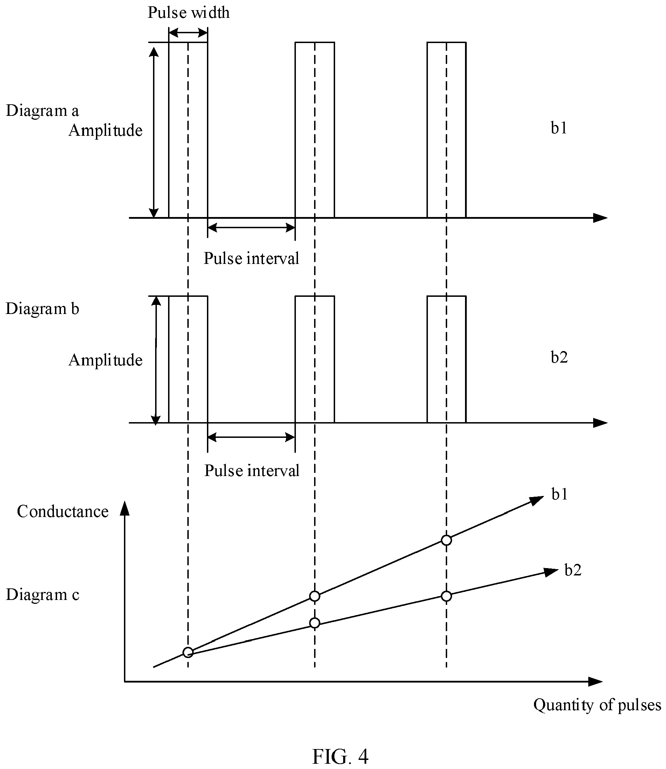

FIG. 4 is a schematic diagram of an electrical characteristic of a conductance device. A diagram a and a diagram b in FIG. 4 respectively show a pulse sequence b1 and a pulse sequence b2. Pulse widths and frequencies of the two pulse sequences are the same, but amplitudes of the two pulse sequences are different. A diagram c in FIG. 4 shows a conductance change that is of the conductance device and that is obtained when the conductance device receives the pulse sequence b1 and the pulse sequence b2 separately.

It can be learned from FIG. 4 that, for a single pulse, a conductance of the conductance device increases as an amplitude of a pulse received by the conductance device increases. For a specific pulse sequence, a conductance of the conductance device linearly increases as a quantity of pulses received by the conductance device increases. For a plurality of pulse sequences, a conductance of the conductance device increases as an amplitude of a pulse sequence received by the conductance device increases.

In this embodiment of this application, a specific form of the conductance device having the characteristic shown in FIG. 3 and/or FIG. 4 is not limited. For example, the conductance device may include a diffusive memristor, a dynamic resistive random access memory (RRAM) with weak initialization processing, a conductive bridging random access memory (CBRAM), or the like. A conductance of each of the several conductance devices may change as a frequency and an amplitude of a pulse sequence received by the conductance device change. However, when the conductance device is applied to the detection circuit 1, one characteristic is usually used, for example, a characteristic that the conductance of the conductance device changes as the frequency of the pulse sequence received by the conductance device changes, or a characteristic that the conductance of the conductance device changes as the amplitude of the pulse sequence received by the conductance device changes.

Optionally, amplitudes of both a first pulse sequence and a second pulse sequence are greater than or equal to a first threshold.

Optionally, an amplitude of a third signal is less than a first threshold.

The first threshold is a critical value of an amplitude of a signal input to a conductance device when a conductance of the conductance device can be changed. In other words, the first pulse sequence can change the conductance of the first conductance device 30, and the second pulse sequence can change the conductance of the second conductance device 40. The third signal neither can change the conductance of the first conductance device 30 nor can change the conductance of the second conductance device 40. A value of the first threshold is related to properties of the first conductance device 30 and the second conductance device 40.

Optionally, the third signal may be a voltage signal or a current signal. In this embodiment of this application, a specific form of the third signal is not limited. For example, the third signal may be a wide pulse sequence (or a single pulse), that is, a pulse sequence (or a single pulse) whose pulse width is greater than or equal to a specific threshold. The third signal may be predefined.

For example, the third signal may be generated by a power supply independent of the detection circuit 1 shown in FIG. 2. For example, the third signal may alternatively be generated by the first pulse sequence generator 10 and/or the second pulse sequence generator 20.

A working principle of the detection circuit 1 is described below.

Step 1: Convert a difference between a first signal and a second signal into a difference between the frequencies/amplitudes of the first pulse sequence and the second pulse sequence, and then convert the difference into a difference between a first conductance and a second conductance.

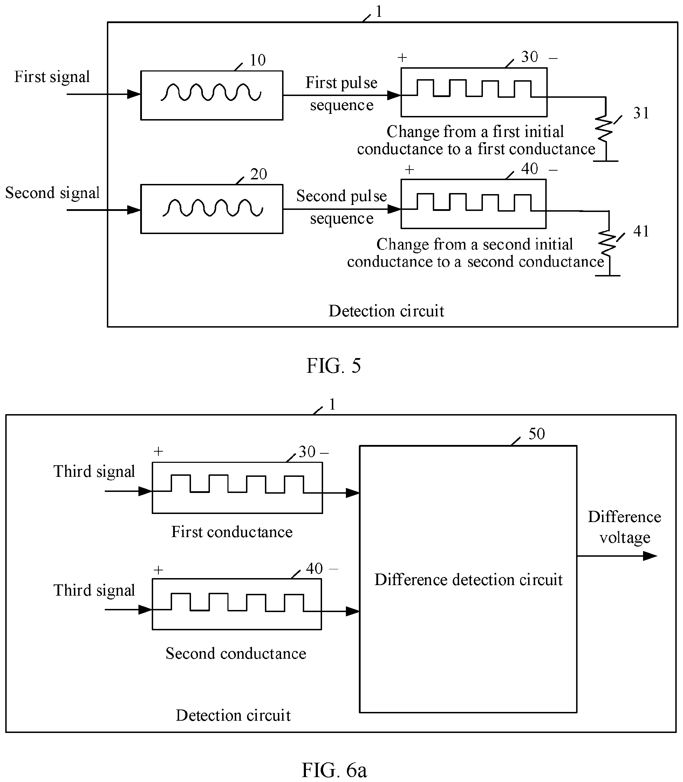

To implement this process, the detection circuit 1 may further include a resistor 31 and a resistor 41. A connection relationship between the resistor 31 and the resistor 41, and another device in the detection circuit 1 may be shown in FIG. 5.

An implementation process of this step may also be shown in FIG. 5. Specifically, in step 1: The first pulse sequence generator 10 and the second pulse sequence generator 20 determine frequencies/amplitudes of generated pulse sequences (that is, the first pulse sequence and the second pulse sequence) respectively based on amplitudes of received signals (that is, the first signal and the second signal). For example, a larger amplitude of the received signal indicates a larger frequency/amplitude of the generated pulse sequence. The first conductance device 30 and the second conductance device 40 are in a same initial state (that is, the first initial conductance and the second initial conductance are the same). Under effect of the pulse sequences of different frequencies/amplitudes, the conductances of the first conductance device 30 and the second conductance device 40 gradually change, and finally maintain different conductance values (that is, the first conductance and the second conductance).

Step 2: Detect the difference between the first conductance and the second conductance.

An implementation process of this step may be shown in FIG. 6a. Specifically, the third signal is input to both the first conductance device 30 and the second conductance device 40, and the difference between the first conductance and the second conductance is detected by using the difference detection circuit 50.

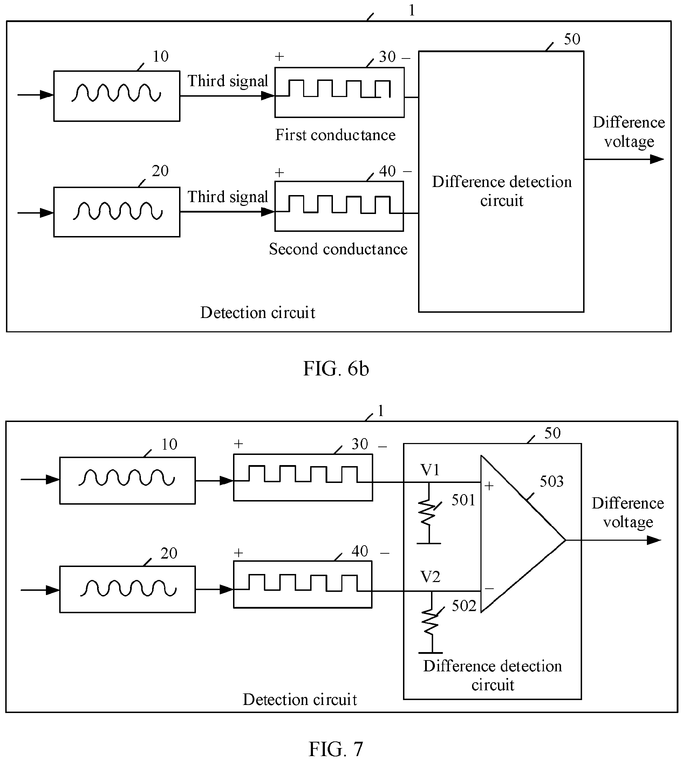

Optionally, the third signal may be signals separately generated by the first pulse sequence generator 30 and the second pulse sequence generator 40. In this case, an implementation process of this step may be shown in FIG. 6b.

A specific implementation of the difference detection circuit 50 is not limited in this embodiment of this application. For example, as shown in FIG. 7, the difference detection circuit 50 includes a first resistor 501, a second resistor 502, and a second differential amplifier 503.

The first pulse sequence generator 10, the first conductance device 30, and the first resistor 501 are sequentially connected in series, and a "connection point between the first resistor 501 and the first conductance device 30" is connected to one input end of the second differential amplifier 503.

The second pulse sequence generator 20, the second conductance device 40, and the second resistor 502 are sequentially connected in series, and a "connection point between the second resistor 502 and the second conductance device 40" is connected to the other input end of the second differential amplifier 503.

An output end of the second differential amplifier 503 is used as an output end of the difference detection circuit 50.

It should be noted that, when the difference detection circuit 50 is implemented by using FIG. 7, with reference to FIG. 5, the first resistor 501 may be reused as the resistor 31, and the second resistor 502 may be reused as the resistor 41. In other words, the first resistor 501 and the second resistor 502 both perform voltage division and current limiting in step 1 and step 2.

Optionally, the first resistor 501 and the second resistor 502 are the same. In this way, the first resistor 501 and the second resistor 502 have a same voltage division degree in step 1 and step 2, so that the difference between the first conductance and the second conductance can more accurately represent the difference between the first pulse sequence and the second pulse sequence, and can accurately represent the difference between the first signal and the second signal, and a detection result of the detection circuit 1 is more accurate.

It can be learned from FIG. 7 that, because the first conductance is different from the second conductance, and the first resistor 501 is the same as the second resistor 502, based on a voltage division relationship, V1 is different from V2, and a difference voltage output by the second differential amplifier 503 represents a difference between V1 and V2.

It should be noted that, in a case in which generation conditions and detection conditions of the first conductance and the second conductance are the same, for example, the first pulse sequence generator 10 and the second pulse sequence generator 20 are pulse sequence generators of a same model, the first conductance device 30 and the second conductance device 40 are conductance devices of a same model, and the first resistor 501 and the second resistor 502 are the same, a larger difference between the first conductance and the second conductance indicates a larger difference between the first signal and the second signal.

Optionally, the first conductance device 30 and the second conductance device 40 are volatile devices. Specifically, the first conductance generated by the first conductance device 30 and the second conductance generated by the second conductance device 40 may be both maintained for a specific time period, and when the time period ends, the first conductance and the second conductance are respectively initialized to the first initial conductance and the second initial conductance. For example, the volatile device may include a diffusive memristor, a dynamic resistive random access memory with weak initialization processing, or the like.

In this case, at a first moment, the first conductance device 30 receives the first pulse sequence, and the second conductance device 40 receives the second pulse sequence. At a second moment, the first conductance device 30 and the second conductance device separately receive the third signal. A time interval between the first moment and the second moment is less than or equal to an interval threshold.

A specific moment (for example, the first moment and the second moment) may not be a strict moment. For example, if a time interval between two time points is less than or equal to a threshold, the two time points may be used as a same moment.

The interval threshold is determined based on a time period in which the first conductance is maintained and a time period in which the second conductance is maintained. For example, the interval threshold is less than "a smallest value of the time period in which the first conductance is maintained and the time period in which the second conductance is maintained". If a model of the first conductance device 30 is the same as a model of the second conductance device 40, the time period in which the first conductance is maintained is the same as the time period in which the second conductance is maintained.

It should be noted that "at a first moment, the first conductance device 30 receives the first pulse sequence, and the second conductance device 40 receives the second pulse sequence" may be replaced with the following: at a first moment, the first conductance device 30 generates the first conductance, and the second conductance device 40 generates the second conductance. In this way, a new embodiment is obtained.

Further, the optional implementation may be understood as follows. When the first conductance device 30 and the second conductance device 40 are volatile devices, in a specific time period starting from an end moment of a process of "converting the difference between the first signal and the second signal into the difference between the first conductance and the second conductance" (or in a specific time period starting from a specific moment in the process), a process of "detecting the difference between the first conductance and the second conductance" is performed.

Optionally, the first conductance device 30 and the second conductance device 40 are non-volatile devices. In other words, the first conductance generated by the first conductance device 30 and the second conductance generated by the second conductance device 40 do not disappear after being generated. For example, the non-volatile device includes a CBRAM and the like.

In this case, the first conductance device 30 is further configured to: after the difference detection circuit 50 outputs the difference voltage, initialize the conductance of the first conductance device 30, that is, initialize the first conductance to the first initial conductance. The second conductance device 40 is further configured to: after the difference detection circuit 50 outputs the difference voltage, initialize the conductance of the second conductance device 30 that is, and initialize the second conductance to the second initial conductance. In this way, subsequently, the detection circuit 1 may be directly used to measure a difference between a new first signal and a new second signal.

In this embodiment of this application, a specific implementation of initializing the conductance of the first conductance device 30 and the conductance of the second conductance device 40 is not limited.

In a possible implementation, if a conductance of each of the first conductance device 30 and the second conductance device 40 changes with a frequency of a pulse sequence received by each of the first conductance device 30 and the second conductance device 40, the conductance of the first conductance device 30 and the conductance of the second conductance device 40 may be initialized in the following manner: The first conductance device 30 is further configured to receive a fourth pulse sequence, where the fourth pulse sequence and the first pulse sequence have a same frequency and opposite directions. The second conductance device 40 is further configured to receive a fifth pulse sequence, where the fifth pulse sequence and the second pulse sequence have a same frequency and opposite directions.

In another possible implementation, if a conductance of each of the first conductance device 30 and the second conductance device 40 changes with an amplitude of a pulse sequence received by each of the first conductance device 30 and the second conductance device 40, the conductance of the first conductance device 30 and the conductance of the second conductance device 40 may be initialized in the following manner: The first conductance device 30 is further configured to receive a sixth pulse sequence, where the sixth pulse sequence and the first pulse sequence have a same amplitude and opposite directions. The second conductance device 40 is further configured to receive a seventh pulse sequence, where the seventh pulse sequence and the second pulse sequence have a same amplitude and opposite directions.

According to the detection circuit 1 provided in this embodiment of this application, a difference between the amplitudes of the first signal and the second signal is converted into the difference between the frequencies or the amplitudes of the pulse sequences, and then is converted into the difference between the first conductance and the second conductance. In this way, the difference between the first signal and the second signal can be indirectly detected by detecting the difference between the first conductance and the second conductance. The detection circuit 1 may be applied to an image edge detection scenario, to reduce calculation steps, improve calculation efficiency, and reduce power consumption of a device.

In one aspect, for each pixel in a to-be-detected image, there are at most four pixels adjacent to the pixel. Therefore, by using the detection circuit 1, a difference between a grayscale value of one pixel and grayscale values of all adjacent pixels of the pixel can be obtained by performing calculation for at most four times. However, in a conventional technology, when a convolution algorithm is used to calculate a difference between grayscale values of adjacent pixels, a magnitude of a convolution kernel is usually large, which causes a large quantity of calculation steps. For example, for a 3*3 convolution kernel, for each pixel in the to-be-detected image, 10 operations (specifically including nine product operations and one summation operation) need to be computed, to obtain the difference between a grayscale value of the pixel and grayscale values of all adjacent pixels of the pixel. Using the detection circuit 1 helps reduce calculation steps, improve calculation efficiency, and reduce power consumption of a device.

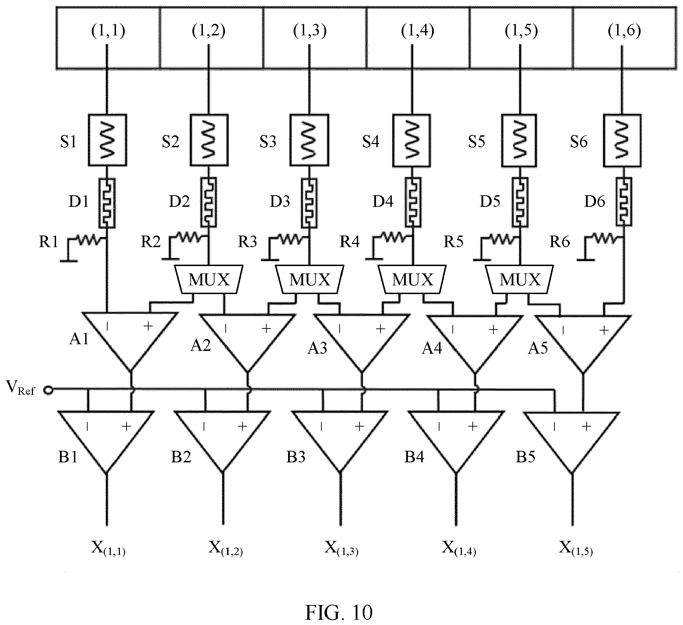

In another aspect, for the entire to-be-detected image, a detection circuit 1 may be designed for each adjacent pixel pair. Some devices shown in examples in FIG. 10 to FIG. 12 may be reused between different detection circuits 1, or there is no device reused between different detection circuits 1. The plurality of detection circuits 1 may perform calculation in parallel, to simultaneously calculate differences between grayscale values of a plurality of adjacent pixel pairs. Compared with a serial computing manner of moving a convolution kernel for each pixel in a conventional technology, the foregoing manner can reduce calculation steps, to improve calculation efficiency and reduce power consumption of a device.

A specific example is used below to describe an application of the detection circuit 1 provided above.

This example is described by using an example in which the detection circuit 1 provided above is applied to an image edge detection scenario. Because each pixel corresponds to one grayscale value, edge detection is to find a location at which a grayscale value changes sharply, that is, to distinguish a difference between grayscale values of two adjacent pixels, so as to determine whether the two pixels are edge pixels.

Based on this, in this scenario, the first signal is an analog signal corresponding to a grayscale value of a first pixel in the to-be-detected image. The second signal is an analog signal corresponding to a grayscale value of a second pixel in the to-be-detected image. The first pixel is adjacent to the second pixel. For example, the first pixel and the second pixel may be two adjacent pixels in any row of the to-be-detected image. For another example, the first pixel and the second pixel may be two adjacent pixels in any column of the to-be-detected image. The analog signals are both current signals or voltage signals.

Specifically, before the detection circuit 1, a front-end sensor (not shown in the figure) may be further disposed, and the front-end sensor is configured to convert grayscale value information of two adjacent pixels in the to-be-detected image into a first analog signal and a second analog signal. The first analog signal and the second analog signal are both voltage signals or current signals.

In an implementation, the first analog signal and the second analog signal are directly used as the first signal and the second signal respectively, and the first signal and the second signal are input to the first pulse sequence generator 10 and the second pulse sequence generator 20 respectively.

In another implementation, an amplifier is disposed between the front-end sensor and the detection circuit 1, and is configured to: after appropriately amplifying the first analog signal and the second analog signal, use the amplified first analog signal and the amplified second analog signal as the first signal and the second signal respectively, and input the first signal and the second signal to the first pulse sequence generator 10 and the second pulse sequence generator 20 respectively.

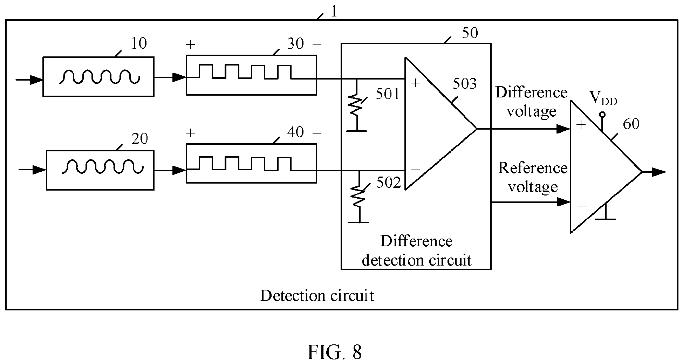

As shown in FIG. 8, the detection circuit 1 further includes a first differential amplifier 60. FIG. 8 is drawn based on FIG. 7.

One input end of the first differential amplifier 60 is configured to receive the difference voltage.

The other input end of the first differential amplifier 60 is configured to receive a reference voltage. The reference voltage may be a voltage critical value corresponding to an edge pixel, and may be specifically determined based on an actual requirement or an empirical value.

A voltage output by the first differential amplifier 60 is used to represent a gradient between the grayscale values of the first pixel and the second pixel.

If grayscale values of all pixels in the to-be-detected image are considered as a two-dimensional discrete function, the gradient between the grayscale values of the first pixel and the second pixel is a derivative of the two-dimensional discrete function in a local range of the first pixel and the second pixel.

The gradient between the grayscale values of the first pixel and the second pixel may further represent whether the first pixel and the second pixel are edge pixels.

When the difference voltage is greater than the reference voltage, the first differential amplifier 60 outputs a high level, where the high level is used to represent that both the first pixel and the second pixel are edge pixels in the to-be-detected image. A voltage amplitude of the high level reflects a degree of a difference between the grayscale values of the first pixel and the second pixel. A larger voltage amplitude indicates a larger difference between the grayscale values of the two pixels, that is, a larger gradient between the grayscale values of the two pixels.

When the difference voltage is less than or equal to the reference voltage, the first differential amplifier 60 outputs a low level such as a zero level, where the low level is used to represent that neither the first pixel nor the second pixel is an edge pixel in the to-be-detected image.

FIG. 8 further shows a supply voltage V_{DD} of the first differential amplifier 60.

A working principle of the detection circuit 1 shown in FIG. 8 may include:

Step 1: Refer to FIG. 5 and the foregoing text description about FIG. 5.

Step 2: Input a third signal to both the first conductance device 30 and the second conductance device 40, and input a reference voltage to the first differential amplifier 60. The difference between the first conductance and the second conductance is detected by using the difference detection circuit 50, and the gradient between the grayscale values of the first pixel and the second pixel is detected by using the first differential amplifier 60.

In this example, an example in which the first differential amplifier 60 is used to determine the gradient between the grayscale values of the first pixel and the second pixel is used for description. In actual implementation, the gradient may be alternatively determined by using another device or a device combination. This is not limited in this embodiment of this application.

FIG. 8 schematically shows a detection circuit for detecting a gradient of adjacent pixels. The following describes a detection circuit for detecting an edge gradient of a to-be-detected image. The edge gradient of the to-be-detected image is usually represented by using an edge gradient image. The edge gradient image is a set of gradients of all pairs of adjacent pixels in the to-be-detected image.

Specifically, in an example in which the to-be-detected image is an image with a resolution of m×n (that is, the to-be-detected image includes m rows and n columns of pixels), a principle of obtaining the edge gradient of the to-be-detected image is as follows.

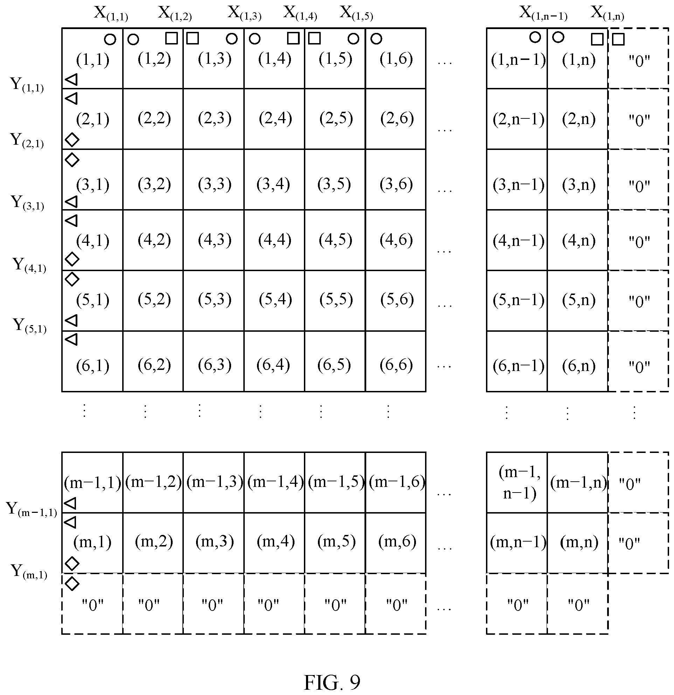

Step 1: Group pixels in the image with a resolution of m×n first. FIG. 9 is a schematic diagram of a grouping result of an image with a resolution of m×n.

Step 2: Process grayscale values of pixels in each group by using the detection circuit 1 shown in FIG. 8, to obtain an X component and a Y component of each pixel in the edge gradient image.

It should be noted that, if it is required that a quantity of pixels of the edge gradient image be the same as a quantity of pixels of the to-be-detected image, zeroes need to be added behind a last row and a last column of the to-be-detected image (as shown by dashed lines in FIG. 9). If it is not required that a quantity of pixels of the edge gradient image be the same as a quantity of pixels of the to-be-detected image, edge detection processing is directly performed on the to-be-detected image, and finally an edge gradient image with a resolution of (m-1)×(n-1) is obtained.

For example, the quantity of pixels of the generated edge gradient image is the same as the quantity of pixels of the to-be-detected image. Pixels in a first row of the to-be-detected image may be divided into two groups, that is, a circle-identified group and a square-identified group. The circle-identified group is processed by using the detection circuit 1 to obtain X_{(1,1)}, X_{(1,3)}, ..., X_{(1,n-1)}, which respectively correspond to pixels (1,1), (1,3), ..., (1,n-1) in the edge gradient image. The square-identified group is processed by using the detection circuit 1 to obtain X_{(1,2)}, X_{(1,4)}, ..., X_{(1,n)}, which respectively correspond to pixels (1,2), (1,4), ..., (1,n) in the edge gradient image. Similarly, another row may also be grouped to obtain a similar output.

Further, a first column of the to-be-detected image is divided into a triangle-identified group and a diamond-identified group. After the two groups are processed by using the detection circuit 1, "Y_{(1,1)}, Y_{(3,1)}, ..., Y_{(m-1, 1)}" and "Y_{(2,1)}, Y_{(4,1)}, ..., Y_{(m,1)}" are respectively obtained, and are respectively corresponding to pixels "(1,1), (3,3), ..., (m-1,1)" and "(2,1), (4,1), ..., (m,1)" in the edge gradient image. Similarly, another column may also be grouped to obtain a similar output.

Step 3: After outputs obtained by processing all rows and all columns of the to-be-detected image by using the detection circuit 1 are obtained, X and Y with same coordinates are combined to obtain a gradient of adjacent pixels of corresponding coordinates in the to-be-detected image. Gradients of all adjacent pixels in the to-be-detected image form an edge gradient image of the to-be-detected image.

The foregoing process may be summarized as follows. Pixels (a,b) and (a,b+1) in the to-be-detected image are processed in groups, to obtain X_{(a,b)}, that is, an X component of the pixel (a,b) in the edge gradient image. Pixels (a,b) and (a+1,b) in the to-be-detected image are processed in groups, to obtain Y_{(a,b)}, that is, a Y component of the pixel (a,b) in the edge gradient image. Finally, the X component and the Y component of the same pixel are combined (for example, combination is performed by using the formula sqrt(X²+Y²)), to obtain the pixel (a,b) in the edge gradient image.

By using the technical solution provided in the first step to the third step, the edge gradient image is obtained, and edge gradient components are obtained in X and Y directions and then combined, so that a small grayscale value difference can be effectively filtered out, and an edge gradient of the to-be-detected image is sharper.

In circuit implementation, a circuit for obtaining the edge gradient of the to-be-detected image may include a plurality of detection circuits, and one pixel pair in the to-be-detected image corresponds to one detection circuit. For example, the detection circuit may be the detection circuit shown in FIG. 8. The pixel pair includes two adjacent pixels in a same row in the to-be-detected image, or two adjacent pixels in a same column in the to-be-detected image.

The following describes several specific implementations of the circuit for obtaining the edge gradient of the to-be-detected image provided in this embodiment of this application.

Manner 1: A first pixel pair in the to-be-detected image corresponds to a first detection circuit. A second pixel pair in the to-be-detected image corresponds to a second detection circuit. The first pixel pair and the second pixel pair both include a same pixel. The first detection circuit and the second detection circuit share a same branch. The branch includes the first pulse sequence generator 10 and the first conductance device 30, or the branch includes the second pulse sequence generator 20 and the second conductance device 40.

For example, both the first detection circuit and the second detection circuit are the detection circuit 1 shown in FIG. 8.

FIG. 10 is a schematic diagram of a structure of a circuit for performing edge detection on elements in a first row of a to-be-detected image. In FIG. 10, an example in which "a gradient of adjacent pixels in pixels (1,1), (1,2), (1,3), (1,4), (1,5), and (1,6) in elements in a first row of a to-be-detected image is detected" is used for description. The circuit shown in FIG. 10 includes sequence generators S1 to S6, conductance devices D1 to D6, resistors R1 to R6, differential amplifiers A1 to A5, differential amplifiers B1 to B5, and four multiplexers (multiplexers, MUX).

Refer to FIG. 10. In an example, the pixel (1,1) and the pixel (1,2) constitute a first pixel pair, and the pixel (1,2) and the pixel (1,3) constitute a second pixel pair. The first detection circuit includes: S1, S2, D1, D2, R1, R2, A1, and B1, and is configured to obtain X_{(1,1)}. The second detection circuit includes: S2, S3, D2, D3, R2, R3, A2, and B2, and is configured to obtain X_{(1,2)}. The first detection circuit and the second detection circuit share a branch by using the device MUX, and the branch includes: S2, D2, and R2. The MUX enables one of the first detection circuit and the second detection circuit to be connected at a same moment.

Other examples are similar, and details are not described herein again.

Based on FIG. 10, a process of performing edge detection may be divided into two steps. Step 1: Generate X_{(1,1)}, X_{(1,3)}, and X_{(1,5)}. Step 2: Generate X_{(1,2)} and X_{(1,4)}. Each MUX connects different lines in the two steps.

If each row of the to-be-detected image uses this circuit structure, all rows of the to-be-detected image may be grouped in parallel, that is, edge detection operations in all row directions are completed in two steps, to generate X components of gradients of all adjacent pixels. Similarly, in a column direction, such an operation may be performed by using the MUX, and Y components of the gradients of all adjacent pixels are generated in two steps. In this case, a total of four parallel operations can be performed to complete calculation of the gradients of all adjacent pixels in the to-be-detected image.

If a manner of processing row by row and column by column is used, a detection circuit of a row-column scale may be reused, and a total of 2*(m+n) operations are required, to complete calculation of the gradients of all adjacent pixels in the to-be-detected image.

Manner 2: A first pixel pair in the to-be-detected image corresponds to a first detection circuit. A second pixel pair in the to-be-detected image corresponds to a second detection circuit. The first pixel pair and the second pixel pair both include a same pixel. The first detection circuit and the second detection circuit share a pulse sequence generator corresponding to the same pixel.

For example, both the first detection circuit and the second detection circuit are the detection circuit 1 shown in FIG. 8.

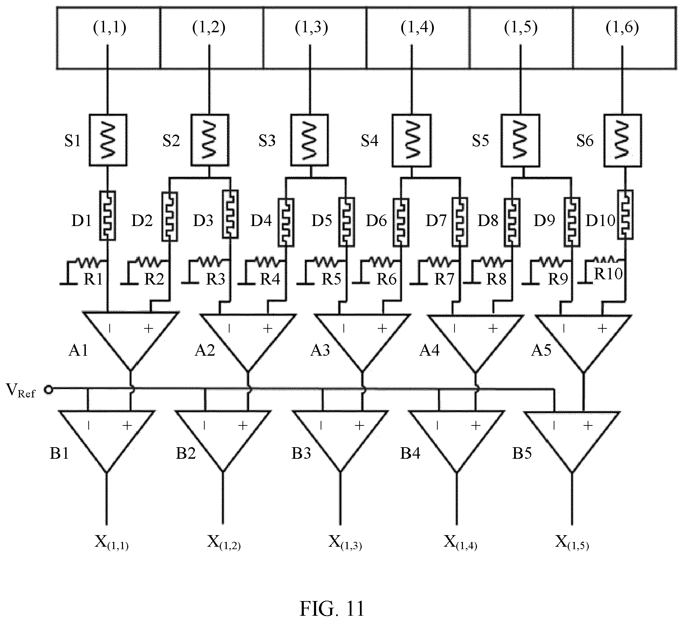

FIG. 11 is a schematic diagram of a structure of a circuit for performing edge detection on elements in a first row of a to-be-detected image. In FIG. 11, an example in which "a gradient of adjacent pixels in pixels (1,1), (1,2), (1,3), (1,4), (1,5), and (1,6) in elements in a first row of a to-be-detected image is detected" is used for description. The circuit shown in FIG. 11 includes sequence generators S1 to S6, conductance devices D1 to D10, resistors R1 to R10, differential amplifiers A1 to A5, and differential amplifiers B1 to B5.

Refer to FIG. 11. In an example, the pixel (1,1) and the pixel (1,2) constitute a first pixel pair, and the pixel (1,2) and the pixel (1,3) constitute a second pixel pair. The two pixel pairs each include the pixel (1,2). The first detection circuit includes: S1, S2, D1, D2, R1, R2, A1, and B1, and is configured to obtain X_{(1,1)}. The second detection circuit includes: S2, S3, D3, D4, R3, R4, A2, and B2, and is configured to obtain X_{(1,2)}. The first detection circuit and the second detection circuit share a pulse sequence generator corresponding to the pixel (1,2), that is, the pulse sequence generator S2. Other examples are similar, and details are not described herein again.

Based on FIG. 11, when edge detection is performed, X_{(1,1)}, X_{(1,2)}, X_{(1,3)}, X_{(1,4)} and X_{(1,5)} may be generated in one step.

If each row of the to-be-detected image uses this circuit structure, all rows of the to-be-detected image may be grouped in parallel, that is, edge detection operations in all row directions are completed in one step, to generate X components that represent gradients of all adjacent pixels. Similarly, such an operation may be performed in column directions to generate Y components that represent the gradients of all adjacent pixels in one step. In this case, a total of two parallel operations can be performed to complete calculation of the gradients of all adjacent pixels in the to-be-detected image.

If a manner of processing row by row and column by column is used, a detection circuit of a row-column scale may be reused, and a total of (m+n) operations are required, to complete calculation of the gradients of all adjacent pixels in the to-be-detected image.

Compared with the foregoing manner 1, the manner 2 can further reduce a quantity of operations. When the detection circuit shown in FIG. 10 or FIG. 11 is used to calculate the gradients of all the adjacent pixels in the to-be-detected image, time is mainly consumed in a switching process of different operations. Therefore, compared with the foregoing manner 1, the manner 2 can reduce a calculation time length.

Manner 3: A first pixel pair in the to-be-detected image corresponds to a first detection circuit. A second pixel pair in the to-be-detected image corresponds to a second detection circuit. A third pixel pair in the to-be-detected image corresponds to a third detection circuit. A fourth pixel pair in the to-be-detected image corresponds to a fourth detection circuit. The first pixel pair, the second pixel pair, the third pixel pair, and the fourth pixel pair all include a same pixel. The first detection circuit, the second detection circuit, the third detection circuit, and the fourth detection circuit share a pulse sequence generator corresponding to the same pixel.

For example, the first detection circuit, the second detection circuit, the third detection circuit, and the fourth detection circuit are all the detection circuit 1 shown in FIG. 8.

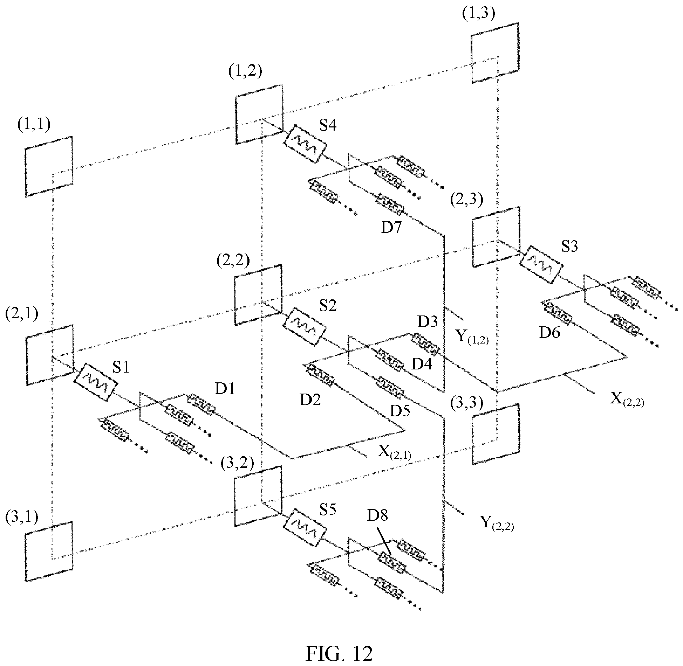

FIG. 12 is a schematic diagram of a structure of a circuit for performing edge detection on some elements in a to-be-detected image. For brevity of the accompanying drawings, FIG. 12 does not show a resistor and a differential amplifier in the detection circuit.

Based on FIG. 12, for a pixel (2,2), in a row direction, the pixel (2,2) is adjacent to a pixel (2,1) and a pixel (2,3) separately; and in a column direction, the pixel (2,2) is adjacent to a pixel (1,2) and a pixel (3,2) respectively.

In other words, the pixel (2,2) and the pixel (2,1) form a first pixel pair, the pixel (2,2) and the pixel (2,3) form a second pixel pair, the pixel (2,2) and the pixel (1,2) form a third pixel pair, and the pixel (2,2) and the pixel (3,2) form a fourth pixel pair. The four pixel pairs each include the pixel (2,2).

The first detection circuit includes: S1, D1, S2, and D2, and is configured to obtain X_{(2,1)}.

The second detection circuit includes: S2, D3, S3, and D6, and is configured to obtain X_{(2,2)}.

The third detection circuit includes: S2, D4, S4, and D7, and is configured to obtain Y_{(1,2)}.

The fourth detection circuit includes: S2, D5, S5, and D8, and is configured to obtain Y_{(2,2)}.

The four detection circuits share a pulse sequence generator corresponding to the pixel (2,2), that is, the pulse sequence generator S2.

Other examples are similar, and details are not described herein again.

The circuit shown in FIG. 12 may be summarized as follows. Four resistors and four adjacent units from top to bottom, and from left to right, are used to form detection circuits for each pixel respectively. In this way, all rows and all columns of the to-be-detected image may be grouped in parallel, that is, edge detection operations of all elements are completed in one step, and X components that represent gradients of all adjacent pixels and Y components that represent the gradients of all adjacent pixels are generated.

Compared with the foregoing manner 1 and manner 2, the manner 3 can further reduce a quantity of operations, to reduce a calculation time length.

Another specific example is used below to describe an application of the detection circuit 1 provided above.

This example is described by using an example in which the detection circuit 1 is applied to a character string difference detection scenario. Specifically, two characters that are in two character strings respectively and have a difference to be detected are used as a character pair. For each character pair, two characters in the character pair are respectively converted into a first signal and a second signal, and the first signal and the second signal are separately input to the detection circuit 1 shown in FIG. 2, FIG. 7, or FIG. 8. A difference voltage obtained by the detection circuit 1 represents a difference between the two characters in the character pair. It should be noted that because parameters of different branches in the detection circuit are not completely the same, an output of the detection circuit may be very small but not zero. In this case, isolation of small signal interference during determining may be implemented based on the first differential amplifier 60 in FIG. 8.

It may be understood that an image edge detection scenario may be considered as detecting a difference between two-dimensional information. A character string difference detection scenario may be considered as detecting a difference between one-dimensional information. Therefore, for a circuit for an overall difference detection of two character strings, refer to the circuit shown in FIG. 10 or FIG. 11.

Certainly, the detection circuit 1 shown in FIG. 2 or FIG. 7 may be further applied to another difference detection scenario. Further, for any two parameters that can be converted into analog signals (for example, voltage signals and current signals), difference detection may be performed based on the detection circuit 1 shown in FIG. 2 or FIG. 7.

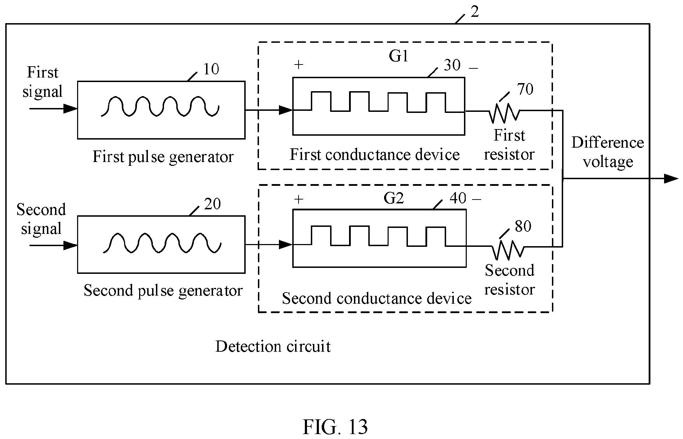

FIG. 13 is a schematic diagram of a structure of a detection circuit 2 according to an embodiment of this application.

The detection circuit 2 includes: a first pulse sequence generator 10, a second pulse sequence generator 20, a first conductance device 30, a second conductance device 40, and a difference detection circuit 50.

The first pulse sequence generator 10 is configured to receive a first signal, and generate a first pulse sequence based on the first signal.

The second pulse sequence generator 20 is configured to receive a second signal, and generate a second pulse sequence based on the second signal. Amplitudes of the first signal and the second signal are different, and frequencies of the first pulse sequence and the second pulse sequence are different.

The first conductance device 30 is configured to receive the first pulse sequence and the second pulse sequence to generate a first conductance.

The second conductance device 40 is configured to receive the first pulse sequence and the second pulse sequence to generate a second conductance.

There is a first resistor 70 and a second resistor 80. The first conductance device 30 and the first resistor 70 are sequentially connected in series, and the second resistor 80 and the second conductance device 40 are sequentially connected in series, and a connection point between the first resistor 70 and the second resistor 80 is used as an output end of the detection circuit 2.

The output end of the detection circuit 2 is configured to output a difference voltage. The difference voltage is used to represent a difference between the first conductance and the second conductance.

When no conflict occurs, for descriptions of related content of the detection circuit 2 provided in this embodiment of this application, refer to the foregoing descriptions of the detection circuit 1. For example, both the first signal and the second signal are current signals or voltage signals. For example, the first conductance device 30 and the second conductance device 40 have a same hardware structure, and have a same initial hardware parameter. For example, the first conductance device 30 and the second conductance device 40 have a same hardware structure, and have a same initial hardware parameter. For example, both the amplitudes of the first pulse sequence and the second pulse sequence are greater than or equal to a first threshold.

The following describes some different characteristics of the detection circuit 2 compared with the detection circuit 1.

Optionally, directions of the first pulse sequence and the second pulse sequence are opposite.

For example, the first pulse sequence is a positive pulse sequence relative to the first conductance device, and the second pulse sequence is a negative pulse sequence relative to the first conductance device. In addition, the first pulse sequence is a negative pulse sequence relative to the second conductance device, and the second pulse sequence is a positive pulse sequence relative to the second conductance device.

For another example, the first pulse sequence is a negative pulse sequence relative to the first conductance device, and the second pulse sequence is a positive pulse sequence relative to the first conductance device. In addition, the first pulse sequence is a positive pulse sequence relative to the second conductance device, and the second pulse sequence is a negative pulse sequence relative to the second conductance device.

Optionally, amplitudes of the positive pulse sequence and the negative pulse sequence are equal.

In the detection circuit 2, the first conductance device 30 and the second conductance device 40 have electrical characteristics as follows.

Optionally, under the positive pulse sequence and the negative pulse sequence, conductance values of the first conductance device 30 and the second conductance device 40 change oppositely.

For example, a conductance of each of the first conductance device 30 and the second conductance device 40 increases as a quantity of pulses in a positive pulse sequence received by each of the first conductance device 30 and the second conductance device 40 increases, and separately decreases as a quantity of pulses in a negative pulse sequence received by each of the first conductance device 30 and the second conductance device 40 increases.

Optionally, when the quantity of pulses in the positive sequence is equal to the quantity of pulses in the negative sequence, under the positive and negative pulse sequences, the first conductance device 30 and the second conductance device 40 have a symmetric relationship in terms of conductance.

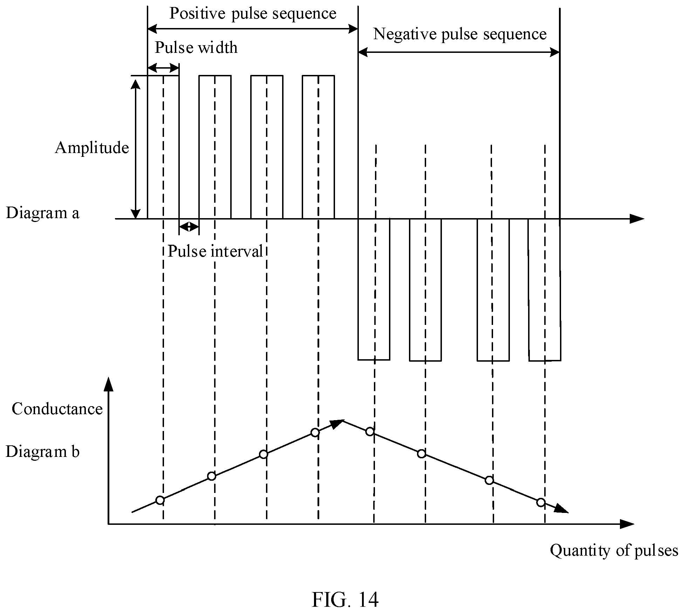

FIG. 14 is a schematic diagram of an electrical characteristic of a conductance device. A diagram a in FIG. 14 shows a positive pulse sequence and a negative pulse sequence, and pulse widths, amplitudes, and frequencies of the two pulse sequences are all the same. A diagram b in FIG. 14 shows that a conductance of a conductance device linearly increases as a quantity of positive pulse sequences received by the conductance device increases, and linearly decreases as a quantity of negative pulse sequences received by the conductance device increases.

Optionally, the conductance of each of the first conductance device 30 and the second conductance device 40 changes with a frequency of a pulse sequence received by each of the first conductance device 30 and the second conductance device 40.

Further, optionally, the conductance of each of the first conductance device 30 and the second conductance device 40 increases as a frequency of a positive pulse sequence received by each of the first conductance device 30 and the second conductance device 40 increases, and decreases as a frequency of a negative pulse sequence received by each of the first conductance device 30 and the second conductance device 40 increases.

In this embodiment of this application, a specific form of the conductance device having the characteristic shown in FIG. 14 is not limited. For example, the conductance device may include a diffusive memristor, a dynamic resistive random access memory with weak initialization processing, a CBRAM, or the like.

The first resistor 70 and the second resistor 80 are current-limiting resistors, and are used to reduce static power consumption and ensure normal operation of the circuit.

Optionally, the first resistor 70 and the second resistor 80 are the same. In this way, a voltage division degree of the first resistor 70 is the same as that of the second resistor 80, so that the difference between the first conductance and the second conductance can more accurately reflect a difference between the first signal and the second signal, and a detection result of the detection circuit 2 is more accurate.

A working principle of the detection circuit 2 shown in FIG. 13 is described below.

When the first signal and the second signal are input to the first pulse sequence generator 10 and the second pulse sequence generator 20 respectively, the first pulse sequence generator 10 and the second pulse sequence generator 20 respectively generate a group of pulse sequences with equal amplitudes and equal pulse widths but opposite directions. The first conductance device 30 and the second conductance device 40 are in a same initial state (initial conductances are the same). Because the first conductance device 30 and the second conductance device 40 are connected back to back (for example, negative electrodes are connected), if the first pulse sequence gradually increases the conductance of the first conductance device 30, the first pulse sequence gradually decreases the conductance of the second conductance device 40. In addition, the second pulse sequence gradually decreases the conductance of the first conductance device 30 and gradually increases the conductance of the second conductance device 40. The first pulse sequence and the second pulse sequence have a contention relationship.

If the frequency of the first pulse sequence is high, within a period of time, an increase in the conductance of the first conductance device 30 is greater than a decrease in the conductance, and the conductance generally increases. Similarly, for the second conductance device 40, the conductance generally decreases.

When the conductances of the first conductance device 30 and the second conductance device 40 change, the difference voltage Vout output at the connection point between the first resistor 70 and the second resistor 80 changes. For the first signal, Vout=G1/(G1+G2)^{∗}V1, and for the second signal, Vout=G2/(G1+G2)^{∗}V2. G1 is a sum of the first conductance and "a conductance corresponding to the first resistor 70". G2 is a sum of the second conductance and "a conductance corresponding to the second resistor 80".

It should be noted that, it can be learned from a comparison between the detection circuit 1 and the detection circuit 2 that the detection circuit 1 completes detection of the difference between the first signal and the second signal by inputting signals twice (that is, inputting the first signal and the second signal for the first time, and inputting the third signal for the second time). The detection circuit 2 can complete detection of the difference between the first signal and the second signal by inputting a signal once (that is, inputting the first signal and the second signal at the same time).

Optionally, the first conductance device 30 and the second conductance device 40 are volatile devices. At a same moment, the first conductance device 30 receives the first pulse sequence, and the second conductance device 40 receives the second pulse sequence.

Optionally, the first conductance device 30 and the second conductance device 40 are non-volatile devices. The first conductance device 30 is further configured to: after the difference detection circuit 2 outputs the difference voltage, initialize the conductance of the first conductance device 30. The second conductance device 40 is further configured to: after the difference detection circuit 2 outputs the difference voltage, initialize the conductance of the second conductance device 40. For related descriptions of an initialization process, refer to the foregoing description. Details are not described herein again.

According to the detection circuit 2 provided in this embodiment of this application, a difference between the amplitudes of the first signal and the second signal is converted into a difference between the frequencies of the pulse sequences, and then is converted into the difference between the first conductance and the second conductance. In this way, the difference between the first signal and the second signal can be indirectly detected by detecting the difference between the first conductance and the second conductance. The detection circuit may be applied to an image edge detection scenario, to reduce calculation steps, improve calculation efficiency, and reduce power consumption of a device. For a specific analysis process, refer to the foregoing process of analyzing beneficial effects of the detection circuit 1. Details are not described herein again.

A specific example is used below to describe an application of the detection circuit 2 provided above.

This example is described by using an example in which the detection circuit 2 provided above is applied to an image edge detection scenario. Based on this, in this scenario, the first signal is an analog signal corresponding to a grayscale value of a first pixel in the to-be-detected image. The second signal is an analog signal corresponding to a grayscale value of a second pixel in the to-be-detected image. The first pixel is adjacent to the second pixel.

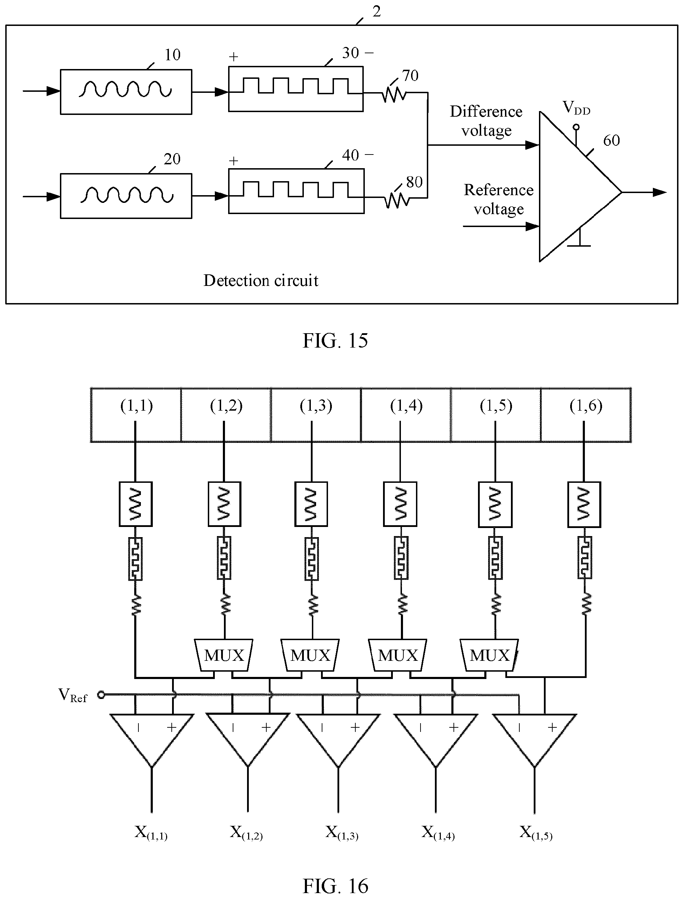

As shown in FIG. 15, the detection circuit 2 may further include a first differential amplifier 60. A function of the first differential amplifier 60 herein is the same as that of the first differential amplifier 60 in the foregoing detection circuit 1. Therefore, for related descriptions, refer to the foregoing description of the detection circuit 1 shown in FIG. 8. Details are not described herein again.

In circuit implementation, a circuit for obtaining an edge gradient of the to-be-detected image may include a plurality of detection circuits, and one pixel pair in the to-be-detected image corresponds to one detection circuit. For example, the detection circuit may be a detection circuit 2 shown in FIG. 15.

The following describes several specific implementations of the circuit for obtaining the edge gradient of the to-be-detected image provided in this embodiment of this application.

Manner 1: A first pixel pair in the to-be-detected image corresponds to a first detection circuit. A second pixel pair in the to-be-detected image corresponds to a second detection circuit. The first pixel pair and the second pixel pair both include a same pixel. The first detection circuit and the second detection circuit share a same branch. The branch includes the first pulse sequence generator 10 and the first conductance device 30, or the branch includes the second pulse sequence generator 20 and the second conductance device 40.

For example, both the first detection circuit and the second detection circuit are the detection circuit 2 shown in FIG. 15.

FIG. 16 is a schematic diagram of a structure of a circuit for performing edge detection on elements in a first row of a to-be-detected image. For descriptions of related content and beneficial effects in the embodiment shown in FIG. 16, refer to descriptions of related content and beneficial effects in the embodiment shown in FIG. 10. Details are not described herein again.

Manner 2: A first pixel pair in the to-be-detected image corresponds to a first detection circuit. A second pixel pair in the to-be-detected image corresponds to a second detection circuit. The first pixel pair and the second pixel pair both include a same pixel. The first detection circuit and the second detection circuit share a pulse sequence generator corresponding to the same pixel.

For example, both the first detection circuit and the second detection circuit are the detection circuit 2 shown in FIG. 15.

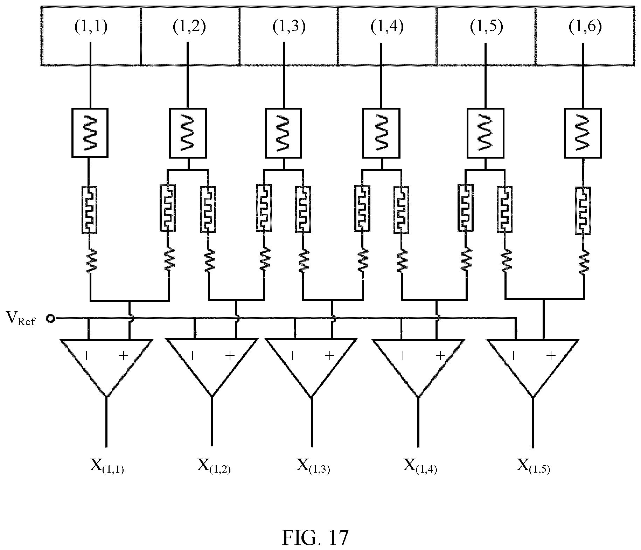

FIG. 17 is a schematic diagram of a structure of a circuit for performing edge detection on elements in a first row of a to-be-detected image. For descriptions of related content and beneficial effects in the embodiment shown in FIG. 17, refer to descriptions of related content and beneficial effects in the embodiment shown in FIG. 11. Details are not described herein again.

Manner 3: A first pixel pair in the to-be-detected image corresponds to a first detection circuit. A second pixel pair in the to-be-detected image corresponds to a second detection circuit. A third pixel pair in the to-be-detected image corresponds to a third detection circuit. A fourth pixel pair in the to-be-detected image corresponds to a fourth detection circuit. The first pixel pair, the second pixel pair, the third pixel pair, and the fourth pixel pair all include a same pixel. The first detection circuit, the second detection circuit, the third detection circuit, and the fourth detection circuit share a pulse sequence generator corresponding to the same pixel.

In this manner, the circuit for obtaining the edge gradient of the to-be-detected image may be obtained with reference to FIG. 12. For related content descriptions and beneficial effects of the circuit, refer to the descriptions and beneficial effects of the related content in the embodiment shown in FIG. 12. Details are not described herein again.

It should be noted that the detection circuit 2 may also be applied to a character string difference detection scenario. For related descriptions of the detection circuit 2, refer to the foregoing related descriptions of the detection circuit 1 applied to the character string difference detection scenario. Certainly, the detection circuit 2 may be further applied to another difference detection scenario. Further, for any two parameters that can be converted into analog signals (for example, voltage signals and current signals), difference detection may be performed based on any detection circuit 2 shown above.

Based on the detection circuit provided in embodiments of this application, an embodiment of this application further provides a chip, and the chip includes any detection circuit provided above.

Correspondingly, an embodiment of this application further provides an electronic device, and the electronic device includes any chip provided above. Correspondingly, the electronic device provided in this application includes a printed circuit board (Printed Circuit Board, PCB), and a chip may be located on the PCB of the electronic device.

Correspondingly, in another implementation, this application further provides an electronic device, and the electronic device includes any detection circuit provided above. Correspondingly, the electronic device provided in this application includes a PCB, and a chip may be located on the PCB of electronic device.

A specific form of the electronic device is not limited in this embodiment of this application. For example, the electronic device may be any electronic device such as a camera, an image recognition device, an industrial detection device, a mobile phone, or a computer.

Correspondingly, an embodiment of this application provides an image processing method. The method includes:
constructing a grayscale value difference detection circuit of adjacent pixels, and performing grayscale value difference detection of a complete image based on X and Y directions to obtain an X component and a Y component of an edge gradient of two adjacent pixels; and
combining an X component and Y component of a same pixel to obtain an edge gradient output of the complete image for implementing an edge detection function.

In a possible design, there are two circuit implementations for detecting a grayscale value difference between adjacent pixels. A principle is that different input grayscale values are first converted into pulse sequences with different frequencies or amplitudes, and then output is completed by using a response difference of a resistor device to the different pulse sequences. If a final output is a zero level, it indicates that no edge exists. If a final output is a high level, it indicates that an edge exists and an amplitude of the high level is directly proportional to an edge gradient. A difference between the two circuits lies in operation steps. If the converted pulse sequences are input to separately function on the resistor devices, two operations are required to complete a final output. If the converted pulse sequences are input to simultaneously function on the resistor devices, only one operation is required to complete a final output.

In a possible design, there are three usage methods combined for the grayscale value difference detection circuit of adjacent pixels. For an image with a resolution of m×n, three structures may be used to concurrently output an edge detection result. If each pixel corresponds to one device, at least four parallel operations are performed. If each pixel corresponds to two devices, at least two parallel operations are performed. If each pixel corresponds to four devices, at least one parallel operation is performed. After a parallel operation output is complete, components of coordinates of a same pixel are combined to obtain edge gradient information of the entire image.

In a possible design, the method further includes:
A device in a basic edge detection unit may be a resistance-volatile device, or may be a resistance-non-volatile device. For the volatile device, two input signals need to be applied simultaneously and an output result needs to be read in time.

Correspondingly, embodiments of this application provide an image processing apparatus and a corresponding electronic device. In an implementation, the image processing apparatus includes a corresponding unit configured to implement the foregoing image processing method. In another implementation, the image processing apparatus includes a corresponding circuit configured to implement the foregoing image processing method. The corresponding electronic device includes the foregoing image processing apparatus.

For descriptions of beneficial effects of a chip, the electronic device, and a method for applying a detection circuit, refer to the foregoing descriptions of beneficial effects of a corresponding detection circuit. Details are not described herein again.

The foregoing descriptions are merely specific implementations of this application, but are not intended to limit the protection scope of this application. Any variation or replacement within the technical scope disclosed in this application shall fall within the protection scope of this application. Therefore, the protection scope of this application shall be subject to the protection scope of the claims.

## Claims

1. A detection circuit, comprising:
a first pulse sequence generator, configured to receive a first signal, and generate a first pulse sequence based on the first signal;
a second pulse sequence generator, configured to receive a second signal, and generate a second pulse sequence based on the second signal, wherein amplitudes of the first signal and the second signal are different, and frequencies or amplitudes of the first pulse sequence and the second pulse sequence are different;
a first conductance device, configured to receive the first pulse sequence to generate a first conductance;
a second conductance device, configured to receive the second pulse sequence to generate a second conductance, wherein
the first conductance device and the second conductance device are further configured to separately receive a third signal; and
a difference detection circuit, configured to connect to the first conductance device and the second conductance device, wherein
the difference detection circuit is further configured to output a difference voltage when both the first conductance device and the second conductance device receive the third signal, and the difference voltage is used to represent a difference between the first conductance and the second conductance.

2. The detection circuit according to claim 1, wherein a conductance of each of the first conductance device and the second conductance device changes with a frequency or an amplitude of a pulse sequence received by each of the first conductance device and the second conductance device.

3. The detection circuit according to claim 2, wherein the conductance of each of the first conductance device and the second conductance device increases as the frequency of the pulse sequence received by each of the first conductance device and the second conductance device increases.

4. The detection circuit according to claim 2, wherein the conductance of each of the first conductance device and the second conductance device increases as the amplitude of the pulse sequence received by each of the first conductance device and the second conductance device increases.

5. The detection circuit according to any one of claims 1 to 4, wherein the conductance of each of the first conductance device and the second conductance device increases as a quantity of pulses in the pulse sequence received by each of the first conductance device and the second conductance device increases.

6. The detection circuit according to any one of claims 1 to 5, wherein the first conductance device and the second conductance device are volatile devices;
at a first moment, the first conductance device receives the first pulse sequence, and the second conductance device receives the second pulse sequence;
at a second moment, the first conductance device and the second conductance device separately receive the third signal; and
a time interval between the first moment and the second moment is less than or equal to an interval threshold.

7. The detection circuit according to any one of claims 1 to 5, wherein the first conductance device and the second conductance device are non-volatile devices;
the first conductance device is further configured to: after the difference detection circuit outputs the difference voltage, initialize the conductance of the first conductance device; and
the second conductance device is further configured to: after the difference detection circuit outputs the difference voltage, initialize the conductance of the second conductance device.

8. The detection circuit according to any one of claims 1 to 7, wherein
both the first signal and the second signal are current signals or voltage signals.

9. The detection circuit according to any one of claims 1 to 8, wherein
the amplitudes of the first pulse sequence and the second pulse sequence are both greater than or equal to a first threshold; and
an amplitude of the third signal is less than the first threshold.

10. The detection circuit according to any one of claims 1 to 9, wherein
the first signal is an analog signal corresponding to a grayscale value of a first pixel in a to-be-detected image;
the second signal is an analog signal corresponding to a grayscale value of a second pixel in the to-be-detected image; and the first pixel is adjacent to the second pixel.

11. The detection circuit according to claim 10, wherein the detection circuit further comprises:
a first differential amplifier, wherein
one input end of the first differential amplifier is configured to receive the difference voltage;
the other input end of the first differential amplifier is configured to receive a reference voltage; and
a voltage output by the first differential amplifier is used to represent a gradient between the grayscale values of the first pixel and the second pixel.

12. The detection circuit according to claim 10 or 11, wherein
one pixel pair in the to-be-detected image corresponds to one detection circuit; and
the pixel pair comprises two adjacent pixels in a same row in the to-be-detected image, or two adjacent pixels in a same column in the to-be-detected image.

13. The detection circuit according to claim 12, wherein
a first pixel pair in the to-be-detected image corresponds to a first detection circuit;
a second pixel pair in the to-be-detected image corresponds to a second detection circuit; and
both the first pixel pair and the second pixel pair comprise a same pixel; the first detection circuit and the second detection circuit share a same branch, and the branch comprises the first pulse sequence generator and the first conductance device, or the branch comprises the second pulse sequence generator and the second conductance device.

14. The detection circuit according to claim 12, wherein
a first pixel pair in the to-be-detected image corresponds to a first detection circuit;
a second pixel pair in the to-be-detected image corresponds to a second detection circuit; and
both the first pixel pair and the second pixel pair comprise a same pixel; and the first detection circuit and the second detection circuit share a pulse sequence generator corresponding to the same pixel.

15. The detection circuit according to claim 14, wherein
a third pixel pair in the to-be-detected image corresponds to a third detection circuit;
a fourth pixel pair in the to-be-detected image corresponds to a fourth detection circuit; and
both the third pixel pair and the fourth pixel pair comprise the same pixel; and the third detection circuit and the fourth detection circuit share a pulse sequence generator corresponding to the same pixel.

16. The detection circuit according to any one of claims 1 to 15, wherein the difference detection circuit comprises:
a first resistor, a second resistor, and a second differential amplifier;
the first pulse sequence generator, the first conductance device, and the first resistor are sequentially connected in series, and a connection point between the first resistor and the first conductance device is connected to one input end of the second differential amplifier;
the second pulse sequence generator, the second conductance device, and the second resistor are sequentially connected in series, and a connection point between the second resistor and the second conductance device is connected to the other input end of the second differential amplifier; and
an output end of the second differential amplifier is used as an output end of the difference detection circuit.

17. A detection circuit, comprising:
a first pulse sequence generator, configured to receive a first signal, and generate a first pulse sequence based on the first signal;
a second pulse sequence generator, configured to receive a second signal, and generate a second pulse sequence based on the second signal, wherein amplitudes of the first signal and the second signal are different, and frequencies of the first pulse sequence and the second pulse sequence are different;
a first conductance device, configured to receive the first pulse sequence and the second pulse sequence to generate a first conductance;
a second conductance device, configured to receive the first pulse sequence and the second pulse sequence to generate a second conductance;
a first resistor and a second resistor, wherein the first conductance device and the first resistor are sequentially connected in series, and the second resistor and the second conductance device are sequentially connected in series, and a connection point between the first resistor and the second resistor is used as an output end of the detection circuit; and
the output end of the detection circuit, configured to output a difference voltage, wherein the difference voltage is used to represent a difference between the first conductance and the second conductance.

18. The detection circuit according to claim 17, wherein a conductance of each of the first conductance device and the second conductance device changes with a frequency of a pulse sequence received by each of the first conductance device and the second conductance device.

19. The detection circuit according to claim 18, wherein the conductance of each of the first conductance device and the second conductance device increases as a frequency of a positive pulse sequence received by each of the first conductance device and the second conductance device each increases, and decrease as a frequency of a negative pulse sequence received by each of the first conductance device and the second conductance device increases.

20. The detection circuit according to any one of claims 17 to 19, the conductance of each of the first conductance device and the second conductance device increases as a quantity of pulses in the positive pulse sequence received by each of the first conductance device and the second conductance device each increases, and decreases as a quantity of pulses in the negative pulse sequence received by each of the first conductance device and the second conductance device increases.

21. A chip, wherein the chip comprises the detection circuit according to any one of claims 1 to 16.

22. A chip, wherein the chip comprises the detection circuit according to any one of claims 17 to 20.

23. An electronic device, wherein the electronic device comprises the chip according to claim 21.

24. An electronic device, wherein the electronic device comprises the chip according to claim 22.

25. An electronic device, wherein the electronic device comprises the detection circuit according to any one of claims 1 to 16.

26. An electronic device, wherein the electronic device comprises the detection circuit according to any one of claims 17 to 20.
